Europäisches Patentamt

(19) European Patent Office

Office européen des brevets

(11) Publication number : **0 385 803 B1**

# EUROPEAN PATENT SPECIFICATION

(45) Date of publication of patent specification :
21.06.95 Bulletin 95/25

(51) Int. Cl.⁶ : **G02F 1/015,** G02F 3/00, H01L 31/0352

(21) Application number : 90302263.0

(22) Date of filing : 02.03.90

(54) **An optical element device.**

(30) Priority : 03.03.89 JP 52651/89
03.03.89 JP 52652/89
08.03.89 JP 55497/89
08.03.89 JP 55498/89
22.11.89 JP 301935/89

(43) Date of publication of application :
05.09.90 Bulletin 90/36

(45) Publication of the grant of the patent :
21.06.95 Bulletin 95/25

(84) Designated Contracting States :
DE FR NL

(56) References cited :
US-A- 4 711 857
TECHNICAL DIGEST SERIES 1988, CONFER-
ENCE ON LASERS AND ELECTRO-OPTICS
vol.7, 25 April 1988, ANAHEIM, US pages 52 -
53; I. BAR-JOSEPH ET AL.: 'Self-electrooptic
effect device and a modulation converter with
InGaAs/InP multiplequantum wells'
APPLIED PHYSICS LETTERS, vol. 45, no. 1, 1
Juli 1984, NEW YORK, US, pages 13 - 15;
D.A.B. MILLER ET AL.: 'Novel hybrid optically
bistable switch: The quantum well self-elec-
tro-optic effect device
ELECTRONICS LETTERS, vol. 23, no. 17,
13August 1987, LONDON, GB, pages 916 - 917;
T.H. WOOD ET AL.: 'High speed 2X2 electri-
cally driven spatial light modulator made with
GaAs/AlGaAs multiple quantum wells (MQWs)'
APPLIED PHYSICS LETTERS, vol. 54, no. 8, 20
February 1989, New York, US, pages 748 - 750;
G. LIVESCU ET AL.: 'High-speed absorption
recovery in quantum well diodes by diffusive
electrical conduction'
APPLIED PHYSICS LETTERS, vol. 47, no. 3, 1
August 1985, New York, US, pages 190 - 192;
T.H. WOOD ET AL.: 'Wavelength-selective
voltage-tunable photodetector made from
multiple quantum wells'

(73) Proprietor : MITSUBISHI DENKI KABUSHIKI
KAISHA
2-3, Marunouchi 2-chome
Chiyoda-ku
Tokyo (JP)

(72) Inventor : Tokuda, Yasunori, c/o Mitsubishi
Denki K. K.
Chuo Kenkyusho,
1-1 Tsukaguchi Honmachi 8-chome
Amagasaki-shi, Hyogo-ken (JP)
Inventor : Tsukada, Noriaki, c/o Mitsubishi
Denki K. K.
Chuo Kenkyusho,
1-1 Tsukaguchi Honmachi 8-chome
Amagasaki-shi, Hyogo-ken (JP)

(74) Representative : Beresford, Keith Denis Lewis
et al
BERESFORD & Co.
2-5 Warwick Court
High Holborn
London WC1R 5DJ (GB)

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 385 803 B1

(56) References cited :

APPLIED PHYSICS LETTERS, vol. 55, no. 8, 21 August 1989, New York, US, pages 711 - 712; Y. TOKUDA ET AL.: 'Incident wavelength dependence of photocurrent bistability by external bias voltage control in a quantum well p-i-n diode'

APPLIED PHYSICS LETTERS, vol. 54, no. 23, 5 June 1989, New York, US, pages 2324 - 2326; Y. TOKUDA ET AL.: 'Self-deformed and hysteric photocurrent spectra of quantum wells with a load resistor'

APPLIED PHYSICS LETTERS, vol. 49, no. 5, August 1986, New York, US, pages 233 - 235; A. LARSSON ET AL.: 'High-speed dual-wavelength demultiplexing and detection in a monolithic superlattice p-i-n waveguide detector array'

PATENT ABSTRACTS OF JAPAN, vol. 8, no. 11 (E-246)(1548) 24 May 1984 & JP A 59027581

PATENT ABSTRACTS OF JAPAN, vol. 9, no. 212 (E-339)(1935) 29 August 1985 & JP A 60074569

APPLIED PHYSICS LETTERS, vol. 52, no. 17, 25April 1988, New York, US, pages 1419 - 1421; A.L. LENTINE ET AL.: 'Symmetric self-electro-optic effect device: Optical set-reset latch'

APPLIED PHYSICS LETTERS, vol. 55, no. 9, 28 August 1989, New York, US pages 828 - 829; T. MIYAZAWA ET AL.: 'Two-wavelength demultiplexing p-i-n GaAs/AlAs photodetector using partially disordered multiple quantum well structures'

APPLIED PHYSICS LETTERS, vol. 56, no. 3, 15 January 1990, New York, US, pages 227 - 229; Y. TOKUDA ET AL.: 'Dual-wavelength multiple quantum well n-i-p-i-n photodetector using an optically bistable abrupt absortion edge'

## Description

### FIELD OF THE INVENTION

The present invention relates to an optical element device which is used as photodetector or a switching element using light. More particularly, the present invention relates to a semiconductor photodetector having a new function, for example, a function of responding to a monochromatic light signal larger than a critical wavelength and not responding to a light signal smaller than the wavelength, showing quite a high selectivity against the monochromatic incident light wavelength.

### BACKGROUND OF THE INVENTION

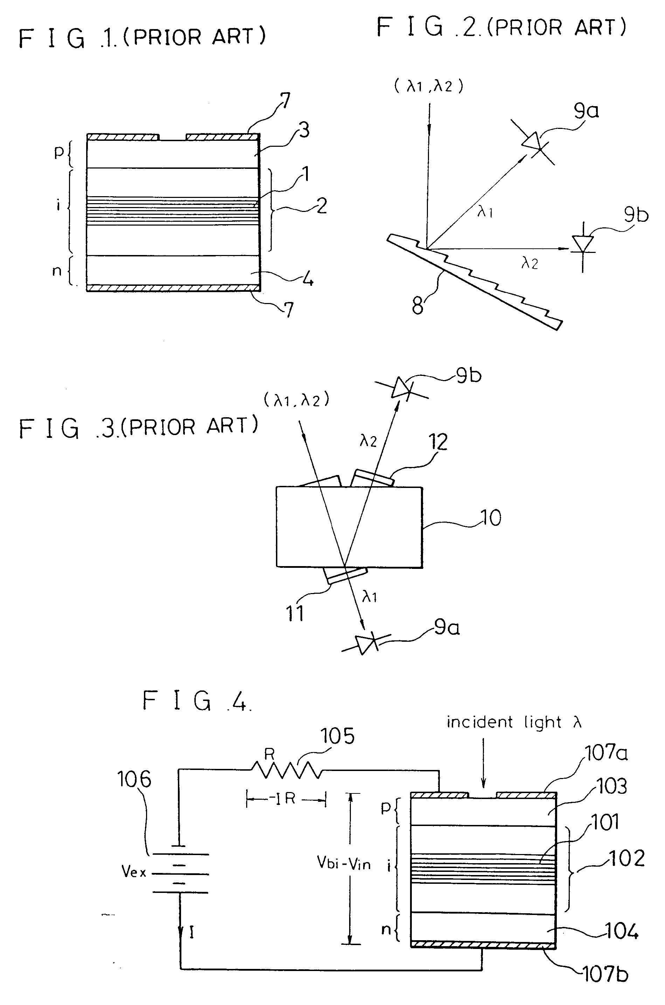

Figure 1 shows a layer structure of a semiconductor photodetector having a quantum well light absorption layer shown in, for example, Appln. Phys. Lett. Vol.47, No.3, 1 August 1985, pp. 190 to 192. In Figure 1, reference numeral 1 designates a multiquantum well light absorption layer which is buried in an intrinsic layer 2. Reference numeral 3 designates a p doped layer, reference numeral 4 designates an n doped layer, and reference numeral 7 designates an electrode.

The device will operate as follows.

When a reverse bias is applied to a quantum well structure as shown in Figure 1, the peak of absorption of incident light in the quantum well layer is shifted toward the longer wavelength side by quantum confined Stark effect. A photodetector having a high wavelength selectivity utilizing an external electric field can be obtained on the basis of this principle.

The prior art photodetector is constituted in such a manner, and an element having relatively intensified wavelength selectivity is obtained. However, the prior art photodetector of such structure is not sufficient to distinguish the optical signal of quite close different wavelengths.

Furthermore, a self-electro-optic effect for obtaining bistability of the output light intensity against the input light intensity is shown in Appl. Phys. Lett. Vol.45, No.1, 1 July 1984, pp. 13 to 15. Although a photodetector which has bistability of the output light intensity against the input light intensity is shown in this article, the bistability of the output light intensity against the input light wavelength and the way of change of the output light intensity against the input light wavelength are not examined.

On the other hand, as a method for detecting a light signal in an optical multiple communication system, a method shown in Figures 2 and 3 is conventionally known. This method is recited in, for example, Japanese Society of Electronics and Communication Engineering, Vo.63, November 1980, p. 1185.

In Figures 2 and 3, reference numeral 8 designates a diffraction grating, reference numerals 9a and 9b designate photodetectors, reference numeral 10 designates a transparent parallel plate, reference numeral 11 designates an interference film filter which transmits only the light having a wavelength at the neighborhood of $\lambda_1$. Reference numeral 12 designates an inteference film filter which transmits only the light having a wavelength at the neighborhood of $\lambda_2$.

The respective detection method will be described.

Herein, it is assumed that the signal is sent out independently, included in the light of wavelength $\lambda_1$ and $\lambda_2$, and these signals are independently converted into electric signals.

In the detection method of Figure 2, the light comprising wavelength $\lambda_1$ and $\lambda_2$ are irradiated to the diffraction grating 8 to be spatially divided into two lights of wavelength $\lambda_1$ and $\lambda_2$, and they are received by the photodetectors 9a and 9b and converted into electric signals.

In the detection method of Figure 3, the light comprising wavelength $\lambda_1$ and $\lambda_2$ are incident to the parallel plates 10, and at first only the light of wavelength $\lambda_1$ is takenout by the interference film filter 11 and is detected by the photodetector 9a to be converted into an electric signal. Next, the light of wavelength $\lambda_2$ which is reflected by the parallel plate 10 is detected by the photodetector 9b through the interference film filter 12, to be converted into an electric signal.

However, in a case where a diffraction grating of Figure 2 is used, although the wavelength separation ability is acceptable, the detection system becomes complicated because the light is spatially divided as well as the incident angle or the like has to be kept constant. In addition, in a case where an interference film filter of Figure 3 is used, the wavelength separation ability is inferior as well as different interference filters have to be provided. Furthermore, in any of photodetectors shown in Figures 2 and 3, there are problems in that the wavelength separation section and the detection section do not comprise the same elements and that they do not have a tuning function.

### SUMMARY OF THE INVENTION

It is an object of the present invention to provide an optical detection element capable of dividing a light comprising different wavelength monochromatic light signals into independent signals with very high wavelength selectively to convert them into electric signals.

It is another object of the present invention to provide an optical detection method capable of converting a monochromatic light signal of particular wavelength with quite high selectivity into electric signals and transmitting the light signal of other wavelengths.

According to one aspect of the present invention there is provided a method of detecting a wavelength multiplexed optical beam, which method comprises: arranging a multiple-quantum-well PIN photo-diode in the path of said wavelength multiplexed optical beam; applying to said photo-diode a reverse-bias voltage through an external series resistor that is such that said photo-diode is tuned to have a photocurrent bistability at a cut-off wavelength lying between component wavelengths of said beam; detecting a beam component of wavelength longer than said cut-off wavelength; and passing one or more beam components of wavelength shorter than said cut-off wavelength.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

## BRIEF DESCRIPTION OF THE DRAWINGS

Figure 1 is a diagram showing a layer structure of a photodetector including a quantum well structure for optical absorption layer;

Figure 2 is a diagram showing optical detection method using a conventional diffraction grating;

Figure 3 is a diagram showing optical detection method using a conventional interference film filter;

Figure 4 is a diagram showing a construction of an optical element device according to a first embodiment of the present invention;

Figure 5 is a diagram for explaining the characteristics of the optical device of Figure 4;

Figure 6 is a diagram showing experimental data of the characteristics of the first embodiment;

Figure 7 is a diagram showing a construction of an optical element according to a second embodiment of the present invention;

Figure 8 is a diagram showing characteristics of the optical element in the second embodiment shown in Figure 7;

Figure 9 is a diagram showing a photodetection method according to a third embodiment of the present invention;

Figure 10 is a diagram showing a photodetection element according to a fourth embodiment of the present invention;

Figure 11 is a diagram for explaining the function of the element shown in Figure 10;

Figure 12 is a diagram showing a photodetection element according to a fifth embodiment of the present invention;

Figure 13 is a diagram showing a photodetection element according to a sixth embodiment of the present invention;

Figure 14 is a diagram showing a photodetection element according to a seventh embodiment of the present invention; and

Figure 15 is a diagram for explaining the function of the element shown in Figure 14.

## DETAILED DESCRIPTION OF THE PREFERRED EMBODIMENT

An embodiment of the present invention will be described in detail with reference to the drawings.

Figure 4 shows an optical element device in accordance with a first embodiment of the present invention. This is produced by sophisticated growth techniques such as molecular beam epitaxy. In Figure 4, reference numeral 101 designates a multi-quantum well optical absorption layer which is embedded in the intrinsic layer 102. In this first embodiment, this optical absorption layer 101 comprises a layer structure in which 100 Angstroms GaAs layer and 100 Angstroms AlGaAs layer are laminated 20 times repetitively. The layers on the multiple quantum well absorption layer 101 in the intrinsic layer 102 is 500 Angstroms AlGaAs. Reference numeral 103 designates a p-type AlGaAs layer. In this first embodiment, this comprises 5000 Angstroms AlGaAs in which Be is doped with a concentration of $5 \times 10^{17}$ $cm^{-3}$. Reference numeral 104 designates an n-type AlGaAs layer. In this first embodiment, this layer comprises 5000 Angstroms AlGaAs in which Si is doped with a concentration of $5 \times 10^{17}$ $cm^{-3}$. Reference numeral 107a designates an upper side electrode having a window, and in this embodiment, a metal such as CrAu is deposited with a thickness of 2000 Angstroms. The size of the window is 800 $\mu m\phi$. Reference numeral 107b designates a lower side electrode, and in this first embodiment this is AuGe/Ni/Au. By the multiple quantum well optical absorption layer 101, intrinsic layer 102, p-type layer 103, n-type layer 104, upper side electrode 107a and lower side electrode 107b, a p-i-n-type structure semiconductor optical element having a quantum well structure for optical absorption layer is constituted, and this first embodiment, the plan configuration is of approximately 1 mm x 1 mm. Reference numeral 105 designates an external resistor one end of which is connected to the upper side electrode 107a. In this embodiment, this external resistor 105 comprises 20 MΩ resistor. Reference numeral 106 designates a constant voltage power supply whose minus electrode is connected to the upper side electrode 107a via the external resistor 106 and its plus electrode is connected to the lower side electrode 107b. In this first embodiment, this constant voltage power supply comprises 1 V DC power supply.

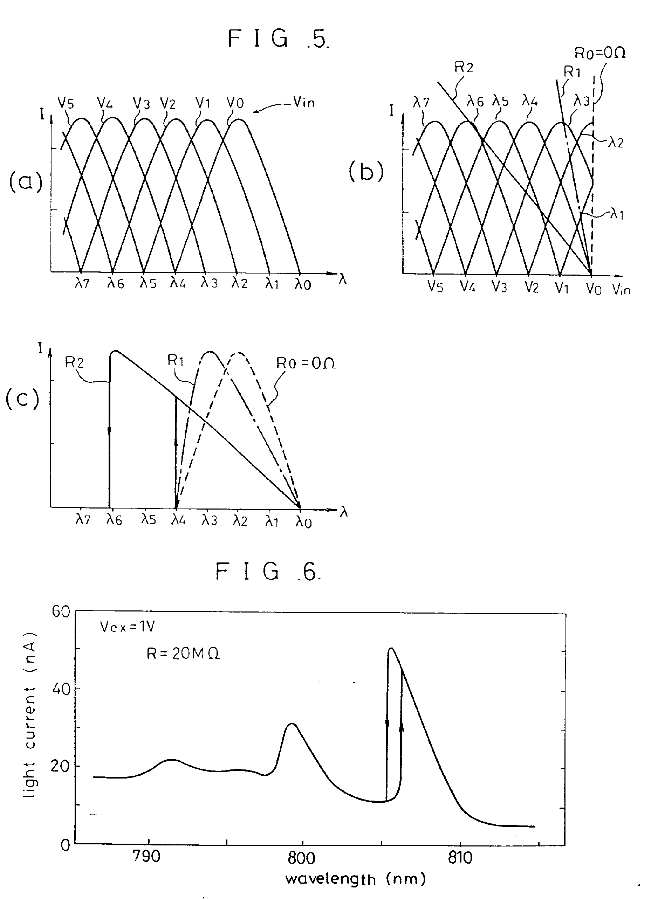

Figure 5(a) shows photocurrent spectra in a case where the internal voltage $V_{in}$ in the quantum well layer 101 with no resistor 105 (a voltage which is actually applied to the element) is varied. $V_{in}$ represents the

sum of the external applied voltage $V_{ex}$ and the built-in voltage $V_{bi}$ (inherent voltage arising at the pn junction). Here, $V_0 = V_{ex}$ and the values $V_1$ to $V_5$ are the internal voltages corresponding to different $V_{ex}$ values. From Figure 5(a), the relation between the internal voltage $V_{in}$ and the photocurrent I against various wavelength $\lambda$ are obtained as shown in Figure 5(b). On the other hand, the photocurrent I is a function of the wavelength $\lambda$, the incident light intensity $P_{in}$, and the internal voltage $V_{in}$ as is represented by the following formula,

$$V_{in} = V_0 - I(V_{in}, P_{in}, \lambda)R,$$

and by drawing this straight line in Figure 5(b), photocurrent spectrum in a case where the resistor 105 shown in Figure 4 is connected is obtained, as shown in Figure 5(c).

Herein, when the external resistor 105 is not connected, that is, $R = O\ \Omega$, the same spectrum as the photocurrent spectrum for the $V_{in} = V_0$ in Figure 5(a) should be obtained.

The response curves shown in Figure 5(b) are obtained from Figure 5(a), and when cross points of the straight line for the resistance value of the external resistor 105 R and the response curves of the respective wavelength are sequentially obtained in Figure 5(b), lines shown in Figure 5(c) are obtained.

When the external resistor 105 has a resistance value or $R_1$, a voltage is generated by the photocurrent at $R_1$, and the internal voltage decreases. Therefore, as is understood from Figure 5(b), the peak wavelength is shifted toward the short wavelength side and self deformation of spectrum as shown by $R_1$ arises in Figure 5(c).

Similarly, when the cross points of the straight line for the resistance value $R_2$ which is larger than $R_1$ and the response curves of the respective wavelengths are sequentially obtained, two cross points (representing bistability and hysteresis) exist between the wavelength $\lambda_4$ and wavelength $\lambda_6 + \alpha$, and a response curve of real line shown in Figure 5(c) is obtained. Note that photocurrent changes steeply and incontinuously at wavelength $\lambda_4$ of a bistable edge.

Even when the hysteresis is not obtained, as the resistor R increases, the change of the photocurrent at the neighborhood of the wavelength $\lambda_4$ becomes drastic.

In this first embodiment, a semiconductor optical element having a response curve shown by real line in Figure 5(c) is utilized, and signal selection with quite high wavelength selectivity at the wavelength $\lambda_4$ as boundary is possible because the element responds at the lower photocurrent level for a monochromatic light of a wavelength between $\lambda_4$ and $\lambda_6 + \alpha$. In other words, when a monochromatic light $\lambda$ of shorter wavelength than $\lambda_4$ is incident, the photocurrent I does not flow, and when a monochromatic light $\lambda$ of longer wavelength than $\lambda_4$ is incident, the photocurrent I flows. Therefore, by observing the photocurrent I, very high wavelength selection of incident light $\lambda$ can be performed.

In this first embodiment, a reverse bias is applied by an external applied voltage $V_{ex}$ by providing a constant voltage power supply 106. However, when the critical wavelength for wavelength selection $\lambda_c$ ($\lambda_4$ shown in Figure 5(c)) is specified, the external applied voltage is not necessarily required and an external resistor may be directly connected between the upper side electrode 107a and the lower side electrode 107b. On the other hand, in a device in which the critical wavelength $\lambda_c$ for selection is varied in the same structure, an external applied voltage $V_{ex}$ is used because $V_{ex}$ changes the wavelength range in which hysteresis arises and the hysteresis width and the like.

According to the first embodiment of the present invention, an external resistor is serially connected to an element having a quantum well optical absorption layer in the i layer of the p-i-n photodiode structure thereby to generate a voltage induced by the photocurrent generated by the light incident to the element, and therefore a drastic change or bistable characteristics of the photocurrent against the wavelength is obtained, thereby enabling utilization as a photodetector in a system having significance in the information transmission in the wavelength such as in optical multiplex communication.

Figure 6 shows a relation between the wavelength and photocurrent of an example in accordance with the first embodiment. This shows hysteresis characteristics obtained against excitation transistion between n = 1 heavy hole and n = 1 electron.

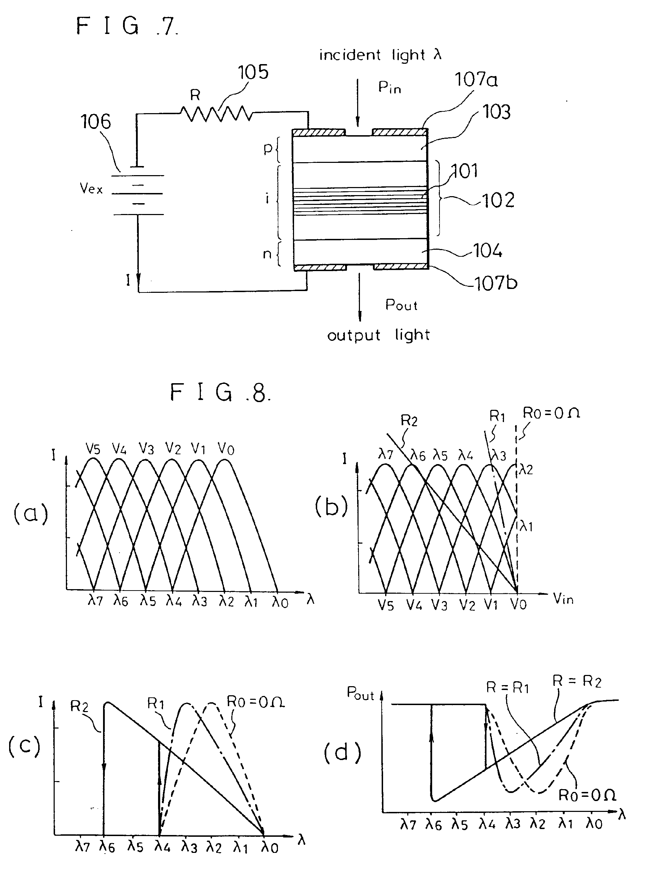

Figure 7 shows a second embodiment of the present invention. Contrary to that the photocurrent I has bistability, hysteresis property, or drastically changes at a critical wavelength and the very high wavelength selective detection of incident light $\lambda$ is possible, as shown in the first embodiment, bistability (hysteresis property) or drastic change against the wavelength of incident light $\lambda$ can be obtained for the intensity of the output light (transmitted light) in a device of Figure 7.

In this second embodiment, the construction is the same as that of the first embodiment except for that a window of 800 micron $\phi$ is provided at the lower side electrode 107b thereby to obtain the output light (the transmitted light).

A filter function provided in this second embodiment will be described with reference to Figure 8.

Figures 8(a), (b), and (c) are the same as those shown in Figures 5(a), (b), and (c), respectively. In general, a photocurrent flows against the absorbed light and the photocurrent spectrum becomes equivalent to the optical absorption spectrum. As a result, from the photocurrent spectrum shown in Figure 8(c), the intensity $P_{out}$ of the output light against the wavelength $\lambda$ of the incident light becomes as shown in Figure 8(d). As is apparent from this Figure 8(d), the output light power $P_{out}$ shows bistability against the wavelength $\lambda$ of the incident light, in which the output light power has two stable points at some wavelength region of the incident light $\lambda$ (in a range from $\lambda_4$ to $\lambda_6$ + $\alpha$ in Figure 8(d)).

In this second embodiment, a semiconductor element having a response curve shown in Figure 8(d) is utilized and quite high selectivity is performed with the wavelength $\lambda_4$ as a critical wavelength. In other words, when the incident light $\lambda$ of wavelength shorter than $\lambda_4$ is incident, the light current I does not flow and an output light power $P_{out}$ is strong. When incident light of wavelength $\lambda$ longer than $\lambda_4$ is incident, the photocurrent I flows and an output light power $P_{out}$ is small. In summary, a filter function which transmits the monochromatic incident light of wavelength below $\lambda_4$, which is a critical wavelength, is provided.

Even when the bistability or hysteresis property is not presented, a characteristic that the output light power $P_{out}$ changes steeply at some wavelength of incident light can be obtained as shown in the dash-dotted line of Figure 8(d).

Furthermore, the characteristics of the bistability can be changed by the external applied voltage $V_{ex}$, the incident light intensity $P_{in}$, and the resistance value R, as mentioned above.

According to a second embodiment of the present invention, an external resistor is serially connected to an element having a quantum well optical absorption layer so that the voltage is induced at the resistor by the photocurrent generated by the incident light, and therefore, the transmission of the light drastically changes at some wavelength or the transmission spectrum shows a bistable property. Therefore, this device can be used as a key device of optical information processing system such as a filter, an optical memory, an optical modulator, a photodetector with high wavelength selectivity.

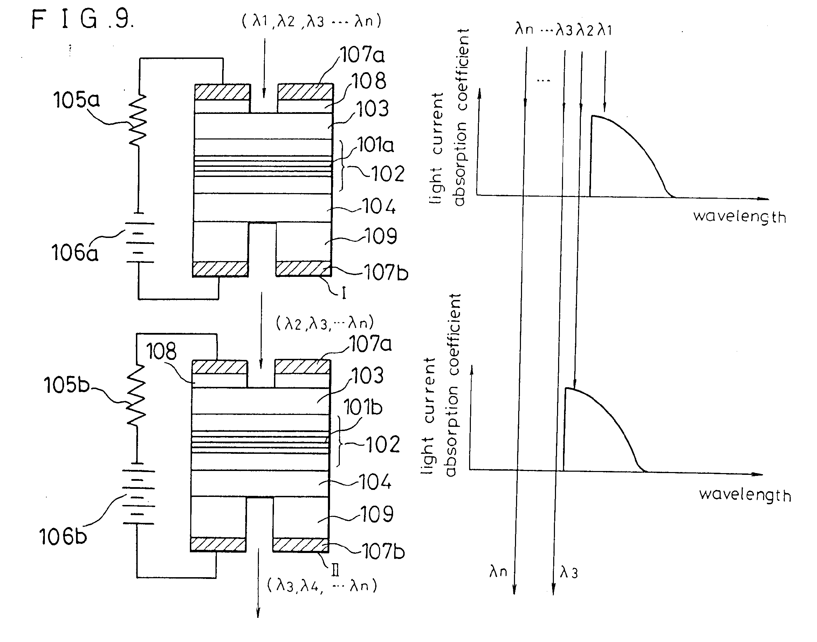

Figure 9 shows a third embodiment of the present invention which is an application example of the novel functions of the semiconductor optical elements shown in the first and second embodiments.

This third embodiment is given a system where monochromatic light detected signals of different wavelengths are separately detected.

In Figure 9, reference character I designates a first stage optical element which only converts the monochromatic optical signal of wavelength of $\lambda_1$ among the incident light into a photocurrent signal and transmits the monochromatic optical signals of wavelength $\lambda_2$ and $\lambda_n$ which are shorter than wavelength $\lambda_1$ as output light, since this element shows bistability property in the photocurrent and the output light intensity against the wavelength of incident light similarly as represented by the response curves shown in Figures 7(c), 8(c) and 8(d). This element has the same structure as that of the second embodiment. That is, this is constituted by an intrinsic layer 102 comprising undoped AlGaAs in which a quantum well optical absorption layer 101a comprising GaAs and AlGaAs is embedded, a layer 103 comprising AlGaAs in which p-type impurities are doped, a layer 104 comprising AlGaAs in which n-type impurities are doped, a layer 108 comprising GaAs in which p-type impurities are doped, a layer 109 comprising GaAs in which n-type impurities are doped, an upper side electrode 107a having an incident window, and a lower side electrode 107b having an output window. Reference numerals 105a and 106a are an external resistor and a constant voltage power supply for the first stage optical element I and these are used to control the absorption characteristics of the first stage optical element I. Reference character II designates a second stage optical element which converts the monochromatic optical signal of wavelength of $\lambda_2$ among the incident light into a photocurrent signal and transmits the monochromatic optical signals of wavelength to $\lambda_3$ to $\lambda_n$ which are shorter than the wavelength $\lambda_2$ as output light. This second optical element is an element representing bistability property in the photocurrent and the output light power against the wavelength of incident light similarly as represented by the response curves shown in Figures 7(c), 8(c) and 8(d). This element has the structure similar to that of the first optical element I. However, the quantum well width of the quantum well optical absorption layer 101b may be differentiated so that the wavelength at which the absorption spectrum against the wavelength of the incident light of the first optical element I changes incontinuously (the wavelength between $\lambda_1$ and $\lambda_2$ in this third embodiment) is shifted toward the shorter wavelength side (to the wavelength between $\lambda_2$ and $\lambda_3$ in this third embodiment). Reference numerals 105b and 106b are an external resistor and a constant voltage power supply for the second stage optical element II and these are used to control and adjust the absorption characteristics of the second stage optical element II.

The operation of the third embodiment will be described. When the monochromatic optical signals of wavelengths of $\lambda_1$, $\lambda_2$, $\lambda_3$, ..., $\lambda_n$ come in from the window of the upper side electrode 107a of the first optical element I, a signal of long wavelength $\lambda_1$ is absorbed in the first optical element I and it is converted into an electric signal (photocurrent). Remaining incident signals of wavelengths of $\lambda_2$, $\lambda_3$, ..., $\lambda_n$ transmit from the lower side electrode 107b of the first element I. Thus, the transmitted light signals of the wavelength $\lambda_2$ to $\lambda_n$ come in from the window of the upper side electrode 107a of the second optical element II, and a monochromatic light signal of wavelength $\lambda_2$ (shorter than the wavelength $\lambda_1$) is absorbed to be converted into an electric signal (photocurrent).

Therefore, in this third embodiment it can be judged whether a signal of wavelength $\lambda_1$ is included

in the incident light from the photocurrent I at the first stage optical element I, and it can be judged whether a signal of wavelength $\lambda_2$ is included in the incident light from the photocurrent I from the second optical element II.

Furthermore, since the first and second optical elements I and II have very drastic changes in the absorption characteristics, the wavelength difference of the monochromatic signals of $\lambda_1$ and $\lambda_2$ can be made quite small.

While in the above-described third embodiment where first stage and second stage optical elements are shown, it is clear that when more than three optical elements are used, a large number of monochromatic wavelength signals can be independently and separately detected.

When more than three optical elements are used, it is required that the absorption in the lower-stage optical element changes drastically and incontinuously at the shorter wavelength. In other words, the third stage optical element which receives the transmitted light from the second optical element II absorbs a monochromatic optical signal of the wavelength of above $\lambda_3$ which is shorter than the wavelength $\lambda_2$, and the fourth stage optical element which receives the transmitted light from the third optical element absorbs a monochromatic optical signal of the wavelength of above $\lambda_4$ which is shorter than the wavelength $\lambda_3$, and in general the n-th stage optical element which receives the transmitted light from the (n-1)th stage optical element absorbs a monochromatic optical signal of the wavelength of above $\lambda_n$ which is shorter than the wavelength $\lambda_{n-1}$.

According to the optical detection method of the third embodiment, an external resistor which has an appropriate value of resistance is connected to the p-i-n structure optical element having a quantum well structure for an optical absorption layer thereby to make the absorption characteristics showing bistability at some wavelength range or drastical and incontinuous change at a wavelength. Thus, only the light signal of a particular wavelength among the incident light is quite selectively converted into an electric signal at an element, and a signal of wavelength component shorter than a critical wavelength in the incident light is transmitted to come in the next stage element, whereby a light detection having quite a high selectivity is enabled by a simple construction.

As a result, signals of a plurality of different monochromatic wavelengths can be detected at a high wavelength selectivity by a simple construction.

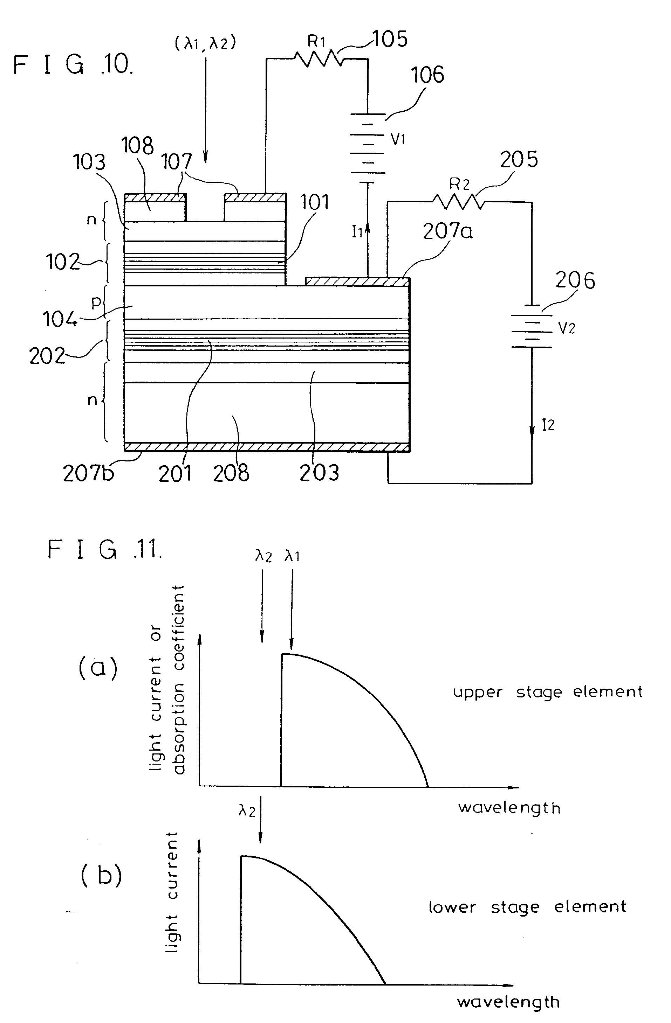

Figure 10 shows a fourth embodiment of the present invention. The first and second optical elements 1 and 2 shown in the first and second embodiments are integrated through the common p-type layer. The fourth embodiment is based on the principle of the third embodiment.

In Figure 10, reference numeral 101 designates a quantum well optical absorption layer and in this fourth embodiment, this layer comprises 30 alternating layers of 100 Angstroms GaAs and 100 Angstroms AlGaAs. Reference numeral 102 designates an intrinsic layer which contains quantum well absorption layer 101. In this fourth embodiment, this layer comprises 2000 Angstroms AlGaAs. Reference numeral 103 designates a first n-type layer produced on an upper surface of this intrinsic layer 102. In this fourth embodiment, this layer comprises 5000 Angstroms AlGaAs in which Si are doped at a concentration of $5 \times 10^{17}$ cm$^{-3}$. Reference numeral 108 designates a second n-type layer with an incident window, produced on this first n-type layer 103. In this fourth embodiment, this second n-type layer 108 comprises GaAs in which Si is doped at a concentration of $2 \times 10^{18}$ cm$^{-3}$. Reference numeral 107 designates a first electrode produced on an upper surface of this second n-type layer 108. In this fourth embodiment, this layer comprises 2000 Angstroms AuGe/Ni/Au. Reference numeral 104 designates a p-type layer produced on a lower surface of the intrinsic layer 102. In this fourth embodiment, this layer comprises 1 micron AlGaAs in which Be is doped at a concentration of $1 \times 10^{18}$ cm$^{-3}$. Reference numeral 207a designates a second electrode produced at a part of an upper surface of the p-type layer, and in this fourth embodiment, this layer comprises CrAu. A first optical element is constituted by the quantum well optical absorption layer 101, intrinsic layer 102, first and second n-type layers 103 and 108, first electrode 107, and p-type layer 104, which absorbs the incident light of wavelength longer than a critical wavelength $\lambda_c$ between $\lambda_1$ and $\lambda_2$ convert it into a photocurrent and transmits the light of wavelength shorter than a critical wavelength $\lambda_c$ between and $\lambda_1$ and $\lambda_2$ to the lower side of the p-type layer 104. Reference numeral 105 designates a first resistor one end of which is connected to the first electrode 107. Reference numeral 106 designates a first external power supply the plus side of which is connected to the other end of the first resistor and the minus side thereof is connected to the second electrode 207a.

Reference numeral 201 designates a quantum well absorption layer and in this fourth embodiment, this layer comprises 30 alternating layers of 100 Angstroms GaAs and 100 Angstroms AlGaAs. Reference numeral 202 designates an intrinsic layer in which the quantum well absorption layer 201 is buried, and in this fourth embodiment, the layer comprises 2000 Angstroms AlGaAs and it is produced at the lower side of the p-type layer 104. Reference numeral 203 designates a third n-type layer produced at a lower surface of this intrinsic layer 202. In this fourth embodiment, this intrinsic layer 202 comprises 5000 Angstroms AlGaAs in which Si is doped at a concentration of $5 \times 10^{17}$ cm$^{-3}$. Reference numeral 208 designates an n-type substrate positioned at the lower surface of the third n-type layer 203 and in this fourth embodiment this layer comprises a GaAs substrate in which Si is doped at a concentration of $2 \times 10^{18}$ cm$^{-3}$. Reference numeral 207b designates a third electrode produced at a lower surface of this substrate and in this fourth embodiment, this third electrode comprises AuGe/Ni/Au. A second optical element is constituted by the quantum well optical absorption layer 201, intrinsic layer 202, third n-type layer 203, substrate 208, third electrode 207b, p-type layer 104, and second electrode layer 207a, which absorbs the light of wavelength shorter than a critical wavelength $\lambda_c$ between $\lambda_1$ and $\lambda_2$ which has transmitted the p-type layer 104 to convert it into a photocurrent. Reference numeral 205 designates a second resistor one end of which is connected to the second electrode 207a. Reference numeral 206 designates a second external power supply the minus side of which is connected to the other end of the second resistor and the plus side thereof is connected to the third electrode.

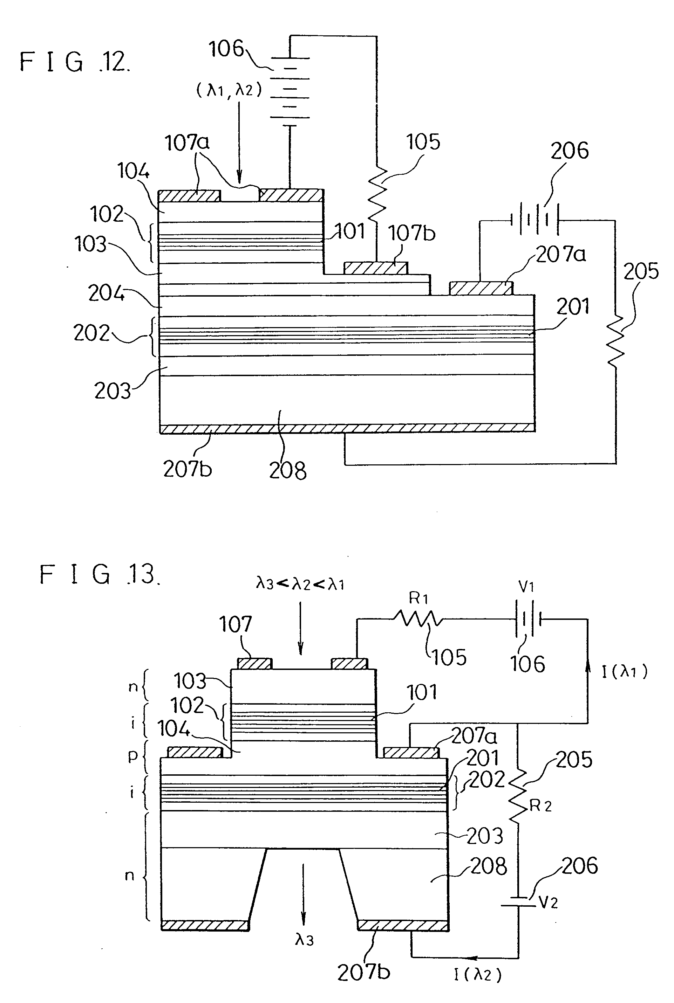

A description is given of the operation of the fourth embodiment. When incident light of wavelength $\lambda_1$ and $\lambda_2$ comes into the incident window of the first electrode 107, in the upper p-i-n structure including a quantum well 101, constituting a first optical element, since the absorption spectrum is established as shown in Figure 11(a), only the light of long wavelength $\lambda_1$ is absorbed and photocurrent flows through the circuit including the first resistor 105. On the other hand, the light of short wavelength $\lambda_2$ transmits the first optical element without absorbed thereat, and it is absorbed at the quantum well 201 of the second optical element positioning at the lower stage, and it is converted into an electric signal as photocurrent flowing in the circuit including the second resistor 205. Herein, the absorption characteristics of the first and the second optical element can be adjusted by controlling the external applied voltage $V_1$ and $V_2$ of the first and second external power supply 106 and 206 or varying the first and second resistors $R_1$ (105) and $R_2$ (205) even in the case where the same quantum well layer structure is adopted. In this fourth embodiment, by adjusting the external applied voltages $V_1$ and $V_2$ of the first and second external voltage power supply 106 and 206 and the resistance values $R_1$ and $R_2$ of the first and second resistors 105 and 205, the photocurrent characteristics against the wavelength of first optical element is established as shown in Figure 11(a) and the photocurrent characteristics against the wavelength of the second optical element is established as shown in Figure 11(b).

In this fourth embodiment, the changes of the absorption characteristics of the optical elements are quite sharp and even when the wavelength $\lambda_1$ and $\lambda_2$ are quite close to each other, these can be selectively detected. As such, this fourth embodiment shows that by integration of a plurality of detectors having different absorption characteristics which change rapidly and incontinuously, the very high wavelength selectivity is obtained.

Figure 12 shows a fifth embodiment of the present invention. While in the fourth embodiment two optical elements are constituted by an n-i-p-i-n structure, in this fifth embodiment an electric separation layer comprising such as an undoped AlGaAs layer is provided and two optical elements are constituted by a p-i-n-i-p-i-n structure.

In these fourth and fifth embodiments, a two stage structure is shown, but a multi-stage structure, that is, a structure including more than three quantum well layers can be fabricated, and a lot of multi-wavelength signals can be independently detected.

Figure 13 shows a sixth embodiment of the present invention. In this sixth embodiment, output windows are provided on the substrate 208 and a third electrode 207b which constitute a second optical element in the fourth embodiment.

As is evident from the foregoing description, according to the fourth to sixth embodiment optical detection elements, a resistor which induces a voltage by the photocurrent generated by the incident light is serially connected to each of optical detection element structure having quantum well structures for light absorption layer, and the absorption of each optical detection element structure shows hysteresis at some wavelength range or changes rapidly and incontinuously at some wavelength, thereby enabling to make the respective quantum well layers detect the monochromatic light of respective particular wavelength with quite high wavelength selectivity to convert it into an electric signal. Therefore, a device which can detect multiple wavelength light signals with quite high wavelength selectivity is constituted by one chip.

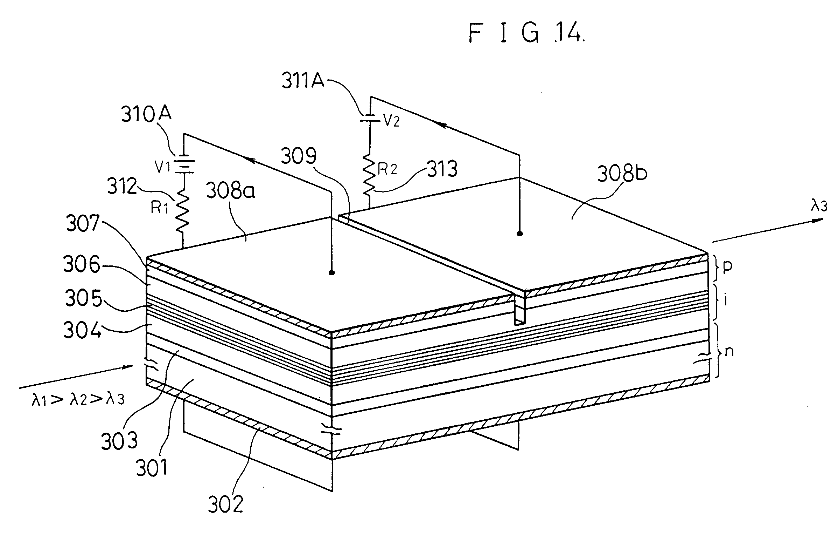

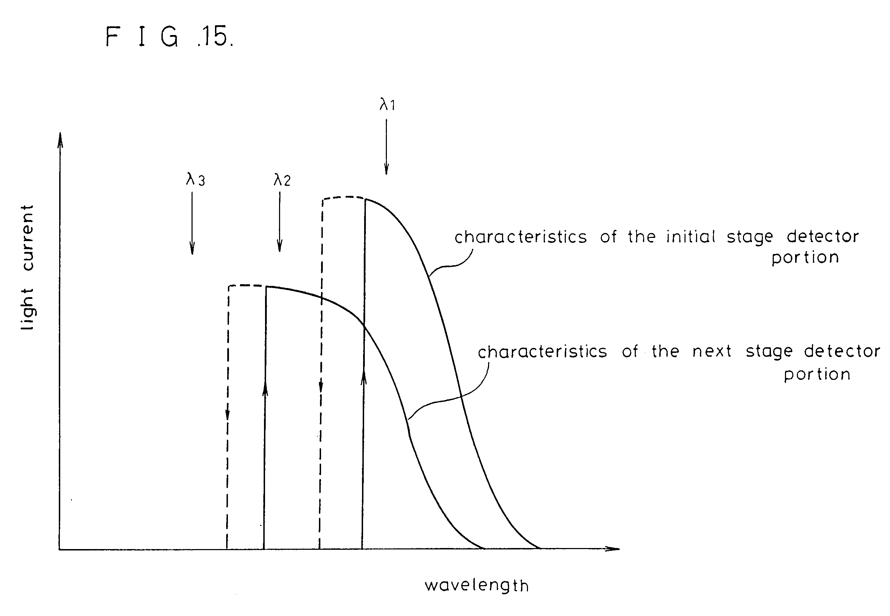

Figures 14 and 15 are diagrams for explaining a seventh embodiment of the present invention. In Figure 14, reference numeral 301 designates an n-type GaAs substrate. Reference numeral 302 designates an electrode evaporated at the GaAs substrate 301. Reference numeral 303 designates an n-type GaAs buffer layer grown on the n-type GaAs substrate 301. Reference numeral 304 designates an n-type AlGaAs layer grown on this n-type GaAs buffer layer 303. Reference numeral 305 designates an undoped GaAs/AlGaAs quantum well structure grown on this n-type AlGaAs layer 304. Reference numeral 306 designates a p-type AlGaAs layer grown on this undoped GaAs/AlGaAs quantum well structure 305. Reference numeral 307 designates a p-type GaAs contact layer grown on the p-type AlGaAs layer 306. Reference numerals 308a and 308b designate electrodes fabricated on this p-type GaAs contact layer 307. Reference numeral 309 designates an element separation groove.

The photodetector of this seventh embodiment is constituted by the above-described n-type GaAs substrate 301 to the element separation region 309, a DC power supply $V_1$ (310A) with the negative terminal of which is connected to the electrode 308a, a resistor $R_1$ (312) with one end of which is connected to the positive terminal of the DC power supply $V_1$ (310A) and the other end of which is connected to the electrode 302, a DC power supply $V_2$ (311A) with the negative terminal of which is connected to the electrode 308b, and a resistor $R_2$ with one end of which is connected to the positive terminal of the DC power supply 311A and the other end of which is connected to the electrode 302.

A description is given of the operation of the seventh embodiment with reference to Figure 15.

Figure 15 shows characteristics representing a relation between the wavelength and the photocurrent of the two segments of the seventh embodiment.

By adjusting the DC power supplies $V_1$ and $V_2$ and the resistors $R_1$ and $R_2$, the photocurrent characteristics of the two photodetector parts can be varied as shown in Figure 15.

Generally, the relation may be made such that $V_1 > V_2$ and $R_1 < R_2$. Herein, although there exists a bistable region, when a monochromatic signal is incident independently, this element responds at the low level of the bistability. Therefore, it operates to detect the light of wavelength $\lambda_1$ at the first stage, to detect the light of wavelength $\lambda_2$ at the next stage, and to transmit the light of wavelength $\lambda_3$. Herein, since the absorption end of the bistability is quite sharp, the wavelength selectivity is quite high. In other words, the wavelength difference of $\lambda_1$, $\lambda_2$, and $\lambda_3$ can be decreased infinitely. Herein, the order of wavelength to be absorbed is reverse to that of the prior art device of Appln.Phys.Lett. 49, 233, (1986).

In summary, this seventh embodiment is obtained by constituting the sixth embodiment shown in Figure 13 in a transverse type element, making the light incident to the layer in parallel, and making the device to detect the wavelength $\lambda_1$ at the front portion of the device, to detect the wavelength $\lambda_2$ at the rear portion of the device and to transmit the wavelength $\lambda_3$ through the device.

In this seventh embodiment of the present invention, an upper electrode of a quantum well p-i-n diode is divided, a power supply and an external resistor are connected to the respective segments, bistable properties of the responses against the wavelength are obtained by utilizing a feedback effect due to an external resistor, and the light of multiple wavelengths are separated with utilizing the steep absorption edge. Therefore, a waveguide photodetector of quite high wavelength selectivity is realized.

While in the above-described seventh embodiment a two-segment type photodetector is described, a three-segment type or more segment type waveguide photodetector in which the upper electrode is divided into such segments can be obtained with the same effects as described above.

As is evident from the foregoing description, according to this seventh embodiment, an upper electrode of p-i-n structure including a quantum well structure intrinsic layer is divided into a multiple of segments and a voltage is applied to between the upper electrode of the respective segments and the lower electrode via a resistor, and a monochromatic light vertically incident to the facet is separately detected at a segment. That is, a photodetector of quite high wavelength selectivity is obtained.

## Claims

1. A method of detecting a wavelength multiplexed optical beam ($\lambda$), which method comprises:
   arranging a multiple-quantum-well PIN photo-diode (101, 102, 103, 104, 107a, 107b) in the path of said wavelength multiplexed optical beam ($\lambda$);
   applying to said photo-diode a reverse-bias voltage through an external series resistor (105) that is such that said photo-diode (101, 102, 103, 104, 107a, 107b) is tuned to have a photocurrent bistability at a cut-off wavelength ($\lambda_4$) lying between component wavelengths of said beam ($\lambda$);
   detecting a beam component of wavelength longer than said cut-off wavelength ($\lambda_4$); and
   passing one or more beam components of wavelength shorter than said cut-off wavelength ($\lambda_4$).

2. A method as claimed in claim 1, which method comprises:
   arranging first and second multiple-quantum-well PIN photo-diodes (I, II) optically in series in the path of said wavelength multiplexed optical beam ($\lambda$);
   applying to said first photo-diode (I) a reverse-bias voltage that is such that said first photo-diode (I) is tuned to have a photocurrent bistability at a cut-off wavelength lying between first and second component wavelengths ($\lambda_1$, $\lambda_2$) of said beam;
   detecting said first component ($\lambda_1$) using said first photodiode, which first component is of wavelength longer than that of said second component ($\lambda_2$);
   passing said second component through said first photo-diode (I) to said second photo-diode (II);
   applying to said second photo-diode (II) a reverse-bias voltage that is such that said second photo-diode, (II) is tuned to detect said second component ($\lambda_2$); and
   detecting said second component using said second photo-diode (II).

3. A method as claimed in claim 2 wherein:
said first and second photo-diodes (I,II) are arranged in the path of a beam comprising said first and second components ($\lambda_1, \lambda_2$), and at least a third component ($\lambda_3$) of shorter wavelength; said reverse-bias voltage applied to said second photo-diode (II) is such that said second photo-diode (II) is tuned to have a photocurrent bistability at a cut-off wavelength lying between said second and third components ($\lambda_2, \lambda_3$); and said third component ($\lambda_3$) is passed by both said first and second photo-diodes (I, II).

4. An optical element device suitable for performing the method as claimed in claim 2, which device comprises:
first and second multiple-quantum-well PIN photo-diodes (I,II) arranged optically in series, the electrodes (107a) of the photo-diodes (I,II) enabling transmission of the optical beam; respective external resistors (105a, 105b) connected in series with said first and second PIN photo-diodes (I,II);
first reverse-bias voltage applying means (106a) connected in series with the first of said external resistors (105a) across said first photo-diode, which means is operable to tune said first photo-diode (I) to have a photocurrent bistability at a cut-off wavelength shorter than a first wavelength ($\lambda_1$); and
second reverse-bias voltage applying means (106b) connected in series with the second of said external resistors (105b) across said second photo-diode (II), which means is operable to tune said second photo-diode (II) to detect optical radiation of a wavelength shorter than said cut-off wavelength.

5. A device as claimed in claim 4 wherein said first and second photo-diodes (I,II) are stacked one upon the other and are such that an optical radiation path is afforded in a direction that is vertical to the p, i and n layers (103, 102, 104) of said first and second photo-diodes (I,II).

6. A device as claimed in claim 4 wherein said first and second photo-diodes (I,II) are arranged side-by-side and are such that an optical radiation path is afforded in a direction that is parallel to the p, i, and n layers (306, 305, 304) of said first and second photo-diodes (I,II).

7. A light detection element as defined in claim 5, wherein said first and second photo-diodes (I,II) have different quantum well structures (101, 202) so that the quantum well structure optical absorption layers convert the light of different wavelength into electric signals.

8. A light detection element as defined in claim 5, wherein the external resistors (105, 205) serially connected to each of the respective first and second photo-diodes (I,II) have different resistance values ($R_1$, $R_2$) so that the quantum well structure optical absorption layers (102, 202) convert the light signals of different wavelength into electric signals.

9. A light detection element as defined in claim 5, which is further provided with a plurality of DC power supplies (106, 206) which are serially connected to the external resistors (105, 205) serially connected to the plurality of photo-diodes (I,II), said plurality of DC power supplies have different voltage values, respective quantum well structure optical absorption layers (101, 201) convert the light signals of different wavelength into electric signals.

10. A light detection element as defined in claim 5, wherein said plurality of photo-diodes (I,II) respectively have p-i-n semiconductor layers (103, 102, 104; 203, 202, 204) and a quantum well structure optical absorption layer (101; 201) is produced in the i-type semiconductor layer (102, 202).

11. A light detection element as defined in claim 10, wherein a separation layer comprising i-type semiconductor layer is provided between said plurality of photo-diodes.

12. A light detection element as defined in claim 10, wherein said adjacent photo-diodes have reverse lamination order of p-i-n type semiconductor layers (103, 102, 104, 202, 203) and one (104) of p- or n-type semiconductor layer is commonly used.

13. A device as claimed in claim 5 wherein said first photo-diode absorbs a light signal of the first or longest wavelength ($\lambda_1$) among the incident light signals and converts it into a light photocurrent and transmits the light signals of wavelength shorter than said longest wavelength ($\lambda_1$) and a second photo-diode which absorbs light signal of the second longest wavelength ($\lambda_2$) which is shorter than the first longest wavelength ($\lambda_1$) among the incident light signals and converts it into photocurrent, wherein:
said second photo-diode comprises:
a semiconductor substrate (208) in which first conductivity type impurities are doped;
a second intrinsic layer (202) in which a multiple quantum well optical absorption layer (201) is buried, produced on a surface of said semiconductor substrate (208);
a second photo-diode second semiconductor layer (104) in which second conductivity type impurities are doped, produced on a surface of said second intrinsic layer (202);

a second photo-diode second electrode (207a) produced on a part of a surface of said second semiconductor layer (104);

a third electrode (207b) produced on the other surface of said semiconductor substrate (208); and

said first photo-diode comprises:

a first photo-diode second semiconductor layer (104) and a first photo-diode second electrode (207a);

a first intrinsic layer (102) in which a multiple quantum well optical absorption layer (101) is buried, produced on a part of a surface of said first photo-diode second semiconductor layer (104);

a first semiconductor layer (103) in which first conductive type impurities are doped, produced on a surface of said first intrinsic layer (102); and

a first electrode (107) provided with an optical window to which light ($\lambda_1,\lambda_2$) comes in, produced on a part of a surface of said first semiconductor layer (103).

14. An optical element device as defined in claim 13, wherein said first photo-diode (I) has a first conductivity type second semiconductor layer (108) between said first semiconductor layer (103) and first electrode (107).

15. An optical element device as defined in claim 14, wherein said first conductivity type second semiconductor layer (108) is provided with an opening at a position corresponding to the optical window of said first electrode (107).

16. An optical element device as defined in claim 13, wherein said second photo-diode (II) is provided with a first conductivity type third semiconductor layer (203) between said semiconductor substrate (208) and said second intrinsic layer (202).

17. An optical element device as defined in claim 13, which further comprises a first resistor (105) connected between said first electrode (107) and said first photo-diode second electrode (207a) and a second resistor (205) connected between said second photo-diode second electrode (207a) and said third electrode (207b).

18. An optical element device as defined in claim 17, wherein said first resistor (105) has a resistance value ($R_1$) representing characteristics changing drastically at a first wavelength of incident light and said second resistor (205) has a resistance value ($R_2$) representing characteristics changing drastically at a second wavelength of incident light.

19. An optical element device as defined in claim 17, which is further provided with a first DC power supply (106) which is serially connected with said first resistor (105) and gives a reverse bias between said first and second semiconductor layers (103, 104) and a second DC power supply (206) which is serially connected with said second resistor (205) and gives a reverse bias between said semiconductor substrate (208) and said second semiconductor layer (104).

20. An optical element device as defined in claim 13, wherein said second photo-diode (II) has a first conductivity type third semiconductor layer (203) between said semiconductor substrate (208) and said second intrinsic layer (202), a hole for outputting light (Fig. 13) is provided on said semiconductor substrate (208) and an output window is produced at a position corresponding to an opening in said third electrode (207b).

21. An optical element device as defined in claim 20, which is further provided with a first resistor (105) connected between said first electrode (107) and said first photo-diode second electrode (207a) and a second resistor (205) connected between said second photo-diode second electrode (207a) and said third electrode (207b).

22. An optical element device as defined in claim 21, wherein said first resistor (105) has a resistance value ($R_1$) representing characteristics drastically changing at a first wavelength of incident light, and said second resistor (205) has a resistance value ($R_2$) representing characteristics drastically changing at a second wavelength of incident light.

23. An optical element device as defined in claim 21, which is further provided with a first DC power supply (106) which is serially connected with said first resistor (105) and gives a reverse bias between said first and second semiconductor layers (103, 104) and a second DC power supply (206) which is serially connected with said second resistor and gives a reverse bias between said semiconductor substrate (208) and said second semiconductor layer (104).

24. A device as claimed in claim 7 having a first photo-diode which absorbs monochromatic light signal of the longest wavelength ($\lambda_1$) longer than a critical wavelength among the incident light signals and converts it into photocurrent and transmits the light signals of wavelength shorter than said critical wavelength and a second optical element which absorbs the light of second longest wavelength ($\lambda_2$) which is shorter than the critical wavelength among the incident light signals and converts it into photocurrent, wherein:

said second photo-diode (II) comprises:

semiconductor substrate (208) in which first conductivity type impurities are doped;

a second intrinsic layer (202) in which a multiple quantum well optical absorption layer (201) is buried, produced on a surface of said semiconductor substrate (208);

a second conductivity type third semiconductor layer (204) in which second conductivity type impurities are doped, produced on a surface of said second intrinsic layer (202);

a fourth electrode (207a) produced on a part of a surface of said second conductivity type third semiconductor layer (204);

a third electrode (207b) produced on the other surface of said semiconductor substrate (208); and

said first photo-diode comprises:

a second semiconductor layer (103) in which first conductivity type impurities are doped, produced at a part on a surface of said second conductivity type third semiconductor layer (204) via a separation layer comprising a semiconductor layer on the third semiconductor layer (204);

a first intrinsic layer (102) in which a multi-quantum well optical absorption layer (101) is buried, produced on a part of a surface of said second semiconductor layer (103);

a first semiconductor layer (104) in which second conductivity type impurities are doped, produced on a surface of said first intrinsic layer (102);

a first electrode (107a) provided with an optical window produced on a part of a surface of said first semiconductor layer (104); and

a second electrode (107b) connected to second semiconductor layer (103).

25. An optical element device as defined in claim 24, wherein said first photo-diode (I) is provided with a second conductivity type fourth semiconductor layer (108) between said first semiconductor layer (104) and said first electrode (107a).

26. An optical element device as defined in claim 25, wherein said second conductivity type fourth semiconductor layer is provided with an opening at a position corresponding to an optical window of said first electrode (107a).

27. An optical element device as defined in claim 24, wherein said second photo-diode is provided with a first conductivity fifth semiconductor layer (203) between said semiconductor substrate (208) and said second intrinsic layer (202).

28. An optical element device as defined in claim 24, which is further provided with a first resistor (105) connected between said first electrode (107a) and said second electrode (107b) and a second resistor (205) connected between said fourth electrode (207a) and said third electrode (207b).

29. An optical element device as defined in claim 28, wherein said first resistor (105) has a resistance value ($R_1$) representing characteristics changing drastically at the first wavelength of incident light and said second resistor (205) has a resistance value ($R_2$) representing characteristics changing drastically at the second wavelength of incident light.

30. An optical element device as defined in claim 28, which is further provided with a first DC power supply (106) which is serially connected with said first resistor (105) and gives a reverse bias to said first semiconductor layer (104) and second semiconductor layer (103) and a second DC (206) power supply which is serially connected with said second resistor (205) and gives a reverse bias to said semiconductor substrate (208) and said third semiconductor layer (204).

31. An optical element device as defined in claim 24, wherein said second photo-diode (II) is provided with a first conductivity type fifth semiconductor layer (203) between said semiconductor substrate (208) and said second intrinsic layer (202), an opening for output light ($\lambda_3$) which has been transmitted by said second intrinsic layer (202) and said fifth semiconductor layer (203) is provided in said semiconductor substrate (208), and an output window is produced at a position of said third electrode (207b) corresponding to said opening.

32. An optical element device as defined in claim 31, which is further provided with a first resistor (105) connected between said first electrode (107a) and said second electrode (107b) and a second resistor (205) connected between said fourth electrode (207a) and said third electrode (207b).

33. An optical element device as defined in claim 32, wherein said first resistor (105) has a resistance value ($R_1$) representing characteristics drastically changing at the first wavelength of incident light and said second resistor (205) has a resistance value ($R_2$) representing characteristics drastically changing at the second wavelength of incident light.

34. An optical element device as defined in claim 32, which is further provided with a first DC power supply (106) which is serially connected with said first resistor (105) and gives a reverse bias to said first semiconductor layer (104) and said second semiconductor layer (103) and a second DC power supply (206) which is serially connected with said second resistor (205) and gives a reverse bias to said semiconductor substrate (208) and said third semiconductor layer (204).

35. A light detection method comprising:

providing a light detection element being constituted such that an external resistor (105) is serially connected to a p-i-n type structure optical element (103, 102, 104) having an optical absorption layer having a quantum well structure (101) so as to generate a voltage by the photocurrent generated by the incident light (λ) and such that the absorption characteristics at the wavelength of incident light of said optical element has a hysteresis or changes discontinuously at some wavelength; and

selectively converting only a light signal of a particular wavelength longer than a critical wavelength into an electric signal and making signals of wavelength shorter than the critical wavelength, transmit as output signal.

36. A light detection device comprising:

a plurality of light detection elements being constituted such that external resistors (105, 205) are serially connected to a plurality of p-i-n type structure optical elements (I,II) having quantum well structures (101, 201) for optical absorption layers so as to generate a voltage by the photocurrent generated by the incident light and such that the absorption characteristics against the wavelength has a hysteresis or changes discontinuously respectively at different wavelengths; and

one element (I) converting quite selectively only the light signal of wavelength longer than the first critical wavelength into electric signals and making signals of wavelengths shorter than the first critical wavelength transmit to the second element (II);

said second element (II) selectively converting the light signal of wavelength longer than the second critical wavelength into an electric signal and making signals of wavelengths shorter than the second critical wavelength transmit to a third element; and

an n-th element quite selectively converting the light signal of wavelength longer than the n-th critical wavelength into an electric signal and making signals of wavelengths shorter than the n-th critical wavelength transmit to the (n+1)th element.

37. A device as claimed in claim 7 in the form of a waveguide type photodetector in which a p-i-n diode structure including a quantum well structure in an intrinsic layer is divided into multiple segments, a voltage is applied to between the upper electrode of the respective stage and the lower electrode via a resistor, monochromatic light signals are separated to be detected at the respective segments.

**Patentansprüche**

1. Ein Verfahren zum Detektieren eines optischen Strahles (λ) gleichzeitig übertragener Wellenlängen, wobei das Verfahren umfaßt:

Anordnen einer Multi-Quantenwannen-PIN-Photodiode (101, 102, 103, 104, 107a, 107b) in der Bahn des optischen Strahles (λ) gleichzeitig übertragener Wellenlängen;

Anlegen einer Sperrvorspannung an die Photodiode durch einen äußeren, in Reihe geschalteten Widerstand (105), die so ist, daß die Photodiode (101, 102, 103, 104, 107a, 107b) eingestellt ist, eine Photostrom-Bistabilität bei einer Grenzwellenlänge ($\lambda_4$) zu besitzen, die zwischen den im Strahl (λ) enthaltenen Wellenlängen liegt;

Detektieren einer Strahlkomponente längerer Wellenlänge als der Grenzwellenlänge ($\lambda_4$); und

Hindurchleiten einer oder mehrer Strahlkomponenten kürzerer Wellenlänge als die Grenzwellenlänge ($\lambda_4$).

2. Ein Verfahren wie in Anspruch 1 beansprucht, wobei das Verfahren umfaßt:

Anordnen erster und zweiter Multi-Quantenwannen-PIN-Photodioden (I, II) optisch in Reihe in der Bahn des optischen Strahles (λ) gleichzeitig übertragener Wellenlängen;

Anlegen einer Sperrvorspannung an die erste Photodiode (I), die so ist, daß die erste Photodiode (I) eingestellt ist, eine Photostrom-Bistabilität bei einer Grenzwellenlänge zu besitzen, die zwischen den im Strahl enthaltenen ersten und zweiten Wellenlängen ($\lambda_1$, $\lambda_2$) liegt;

Detektieren der ersten Komponente ($\lambda_1$) unter Verwendung der ersten Photodiode, wobei die erste Komponente von längerer Wellenlänge ist als die zweite Komponente ($\lambda_2$);

Hindurchleiten der zweiten Komponente durch die erste Photodiode (I) zu der zweiten Photodiode (II);

Anlegen einer Sperrvorspannung an die zweite Photodiode (II), die so ist, daß die zweite Photodiode (II) eingestellt ist, die zweite Komponente ($\lambda_2$) zu detektieren; und

Detektieren der zweiten Komponente unter Verwendung der zweiten Photodiode (II).

3. Ein Verfahren wie in Anspruch 2 beansprucht, worin:

die ersten und zweiten Photodioden (I, II) in der Bahn eines Strahles angeordnet sind, der die ersten und zweiten Komponenten ($\lambda_1$, $\lambda_2$) und wenigstens eine dritte Komponente ($\lambda_3$) kürzerer Wellenlänge umfaßt;

die an die zweite Photodiode (II) angelegte Sperrvorspannung so ist, daß die zweite Photodiode (II) eingestellt ist, eine Photostrom-Bistabilität bei einer Grenzwellenlänge zu besitzen, die zwischen den zweiten und dritten Komponenten ($\lambda_2$, $\lambda_3$) liegt; und

die dritte Komponente ($\lambda_3$) von sowohl der ersten als auch der zweiten Photodiode (I, II) hindurchgeleitet wird.

4. Ein optisches Bauelement, das zum Durchführen des Verfahrens wie in Anspruch 2 beansprucht geeignet ist, wobei das Bauelement umfaßt:

erste und zweite optisch in Reihe angeordnete Multi-Quantenwannen-PIN-Photodioden (I, II), wobei die Elektroden (107a) der Photodioden (I, II) die Übertragung des optischen Strahles ermöglichen;

zugehörige, mit den ersten und zweiten PIN-Photodioden (I, II) in Reihe geschaltete äußere Widerstände (105a, 105b);

eine erste, mit dem ersten der äußeren Widerstände (105a) in Reihe geschaltete Einrichtung (106a) zum Anlegen von Sperrvorspannung über der ersten Photodiode, wobei diese Einrichtung betriebsfähig ist, die erste Photodiode (I) einzustellen, eine Photostrom-Bistabilität bei einer Grenzwellenlänge kürzer als die erste Wellenlänge ($\lambda_1$) zu besitzen; und

eine zweite, mit dem zweiten der äußeren Widerstände (105b) in Reihe geschaltete Einrichtung (106b) zum Anlegen von Sperrvorspannung über der zweiten Photodiode (II), wobei diese Einrichtung betriebsfähig ist, die zweite Photodiode (II) einzustellen, optische Strahlung einer kürzeren Wellenlänge als die Grenzwellenlänge zu detektieren.

5. Ein Bauelement wie in Anspruch 4 beansprucht, worin die ersten und zweiten Photodioden (I, II) eine auf der anderen gestapelt sind und solcherart sind, daß ein optischer Strahlengang in einer Richtung gewährleistet wird, die senkrecht zu den p-, i- und n-Schichten (103, 102, 104) der ersten und zweiten Photodioden (I, II) ist.

6. Ein Bauelement wie in Anspruch 4 beansprucht, worin die ersten und zweiten Photodioden (I, II) Seite an Seite angeordnet sind und solcherart sind, daß ein optischer Strahlengang in einer Richtung gewährleistet wird, die parallel zu den p-, i- und n-Schichten (306, 305, 304) der ersten und zweiten Photodioden (I, II) ist.

7. Ein Lichtdetektionselement wie in Anspruch 5 definiert, worin die ersten und zweiten Photodioden (I, II) verschiedene Quantenwannenstrukturen (101, 102) besitzen, sodaß die Licht absorbierenden Schichten mit Quantenwannenstruktur das Licht verschiedener Wellenlängen in elektrische Signale umwandeln.

8. Ein Lichtdetektionselement wie in Anspruch 5 definiert, worin die seriell mit jeder von den zugehörigen ersten und zweiten Photodioden (I, II) verbundenen äußeren Widerstände (105, 205) verschiedene Widerstandswerte ($R_1$, $R_2$) besitzen, sodaß die Licht absorbierenden Schichten (102, 202) mit Quantenwannenstruktur die Lichtsignale verschiedener Wellenlängen in elektrische Signale umwandeln.

9. Ein Lichtdetektionselement wie in Anspruch 5 definiert, welches desweiteren mit einer Vielzahl von Gleichstromversorgungsgeräten (106, 206) ausgestattet ist, die seriell mit den seriell mit der Vielzahl der Photodioden (I, II) verbundenen äußeren Widerständen (105, 205) verbunden sind, wobei die Vielzahl der Gleichstromversorgungsgeräte verschiedene Spannungswerte besitzen und die zugehörigen Licht absorbierenden Schichten (101, 201) mit Quantenwannenstruktur die Lichtsignale verschiedener Wellenlängen in elektrische Signale umwandeln.

10. Ein Lichtdetektionselement wie in Anspruch 5 definiert, worin die Vielzahl der Photodioden (I, II) p-i-n-Halbleiterschichten (103, 102, 104 beziehungsweise 203, 202, 204) besitzen und eine Licht absorbierende Schicht (101; 201) mit Quantenwannenstruktur in der Halbleiterschicht (102; 202) vom i-Typ erzeugt wurde.

11. Ein Lichtdetektionselement wie in Anspruch 10 definiert, worin eine eine Halbleiterschicht vom i-Typ umfassende Trennschicht zwischen der Vielzahl der Photodioden bereitgestellt ist.

12. Ein Lichtdetektionselement wie in Anspruch 10 definiert, worin die benachbarten Photodioden umgekehrte Schichtreihenfolge der Halbleiterschichten vom p-i-n-Typ (103, 102, 104, 202, 203) besitzen und eine (104) Halbleiterschicht vom p- oder n-Typ gemeinsam genutzt wird.

13. Ein Bauelement wie in Anspruch 5 beansprucht, worin die erste Photodiode unter den einfallenden Lichtsignalen ein Lichtsignal der ersten oder längsten Wellenlänge ($\lambda_1$) absorbiert und es in einen Lichtphotostrom umwandelt und die Lichtsignale kürzerer Wellenlänge als der längsten Wellenlänge ($\lambda_1$) überträgt und einer zweiten Photodiode, die unter den einfallenden Lichtsignalen ein Lichtsignal der zweiten längsten Wellenlänge ($\lambda_2$), die kürzer als die erste längste Wellenlänge ($\lambda_1$) ist, absorbiert und es in einen Photostrom umwandelt, worin:

die zweite Photodiode umfaßt:

ein Halbleitersubstrat (208), das mit Fremdatomen vom ersten Leitfähigkeitstyp dotiert ist;

eine zweite auf einer Oberfläche des Halbleitersubstrats (208) erzeugte eigenleitende Schicht (202), in der eine Licht absorbierende Multi-Quantenwannenschicht (201) eingelassen ist;

eine zweite auf einer Oberfläche der zweiten eigenleitenden Schicht (202) erzeugte Halbleiterschicht (104) der zweiten Photodiode, die mit Fremdatomen vom zweiten Leitfähigkeitstyp dotiert ist;

eine zweite auf einem Teil einer Oberfläche der zweiten Halbleiterschicht (104) erzeugte Elektrode (207a) der zweiten Photodiode;

eine dritte auf der anderen Oberfläche des Halbleitersubstrats (208) erzeugte Elektrode (207b); und

die erste Photodiode umfaßt:

eine zweite Halbleiterschicht (104) der ersten Photodiode und eine zweite Elektrode (207a) der ersten Photodiode;

eine erste auf einem Teil einer Oberfläche der zweiten Halbleiterschicht (104) der ersten Photodiode erzeugte eigenleitende Schicht (102), in der eine Licht absorbierende Multi-Quantenwannenschicht (101) eingelassen ist;

eine erste auf einer Oberfläche der ersten eigenleitenden Schicht (102) erzeugte Halbleiterschicht (103), die mit Fremdatomen vom ersten Leitfähigkeitstyp dotiert ist; und

eine auf einem Teil einer Oberfläche der ersten Halbleiterschicht (103) erzeugte, mit einem optischen Fenster, zu dem Licht ($\lambda_1, \lambda_2$) hereinkommt, versehene erste Elektrode (107).

14. Ein optisches Bauelement wie in Anspruch 13 definiert, worin die erste Photodiode (I) zwischen der ersten Halbleiterschicht (103) und der ersten Elektrode (107) eine zweite Halbleiterschicht (108) vom ersten Leitfähigkeitstyp besitzt.

15. Ein optisches Bauelement wie in Anspruch 14 definiert, worin die zweite Halbleiterschicht (108) vom ersten Leitfähigkeitstyp an einer zum optischen Fenster der ersten Elektrode (107) passenden Position mit einer Öffnung versehen ist.

16. Ein optisches Bauelement wie in Anspruch 13 definiert, worin die zweite Photodiode (II) zwischen dem Halbleitersubstrat (208) und der zweiten eigenleitenden Schicht (202) mit einer dritten Halbleiterschicht (203) vom ersten Leitfähigkeitstyp ausgestattet ist.

17. Ein optisches Bauelement wie in Anspruch 13 definiert, das desweiteren einen ersten Widerstand (105), der zwischen die erste Elektrode (107) und die zweite Elektrode (207a) der ersten Photodiode geschaltet ist, und einen zweiten Widerstand (205), der zwischen die zweite Elektrode (207a) der zweiten Photodiode und die dritte Elektrode (207b) geschaltet ist, umfaßt.

18. Ein optisches Bauelement wie in Anspruch 17 definiert, worin der erste Widerstand (105) einen Widerstandswert ($R_1$) besitzt, der Eigenschaften repräsentiert, die sich bei einer ersten Wellenlänge einfallenden Lichtes drastisch ändern, und der zweite Widerstand (205) einen Widerstandswert ($R_2$) besitzt, der Eigenschaften repräsentiert, die sich bei einer zweiten Wellenlänge einfallenden Lichtes drastisch ändern.

19. Ein optisches Bauelement wie in Anspruch 17 definiert, das desweiteren mit einem ersten Gleichstromversorgungsgerät (106), das mit dem ersten Widerstand (105) in Reihe geschaltet ist und eine Sperrvorspannung zwischen den ersten und zweiten Halbleiterschichten (103, 104) anlegt, und einem zweiten Gleichstromversorgungsgerät (206), das mit dem zweiten Widerstand (205) in Reihe geschaltet ist und eine Sperrvorspannung zwischen dem Halbleitersubstrat (208) und der zweiten Halbleiterschicht (104) anlegt, ausgestattet ist.

20. Ein optisches Bauelement wie in Anspruch 13 definiert, worin die zweite Photodiode (II) zwischen dem Halbleitersubstrat (208) und der zweiten eigenleitenden Schicht (202) eine dritte Halbleiterschicht (203) vom ersten Leitfähigkeitstyp besitzt, wobei auf dem Halbleitersubstrat (208) ein Loch zum Ausgeben von Licht (Fig. 13) bereitgestellt ist und ein Ausgabefenster an einer zu einer Öffnung in der dritten Elektrode (207b) passenden Position erzeugt ist.

21. Ein optisches Bauelement wie in Anspruch 20 definiert, das desweiteren mit einem ersten Widerstand (105), der zwischen die erste Elektrode (107) und die zweite Elektrode (207a) der ersten Photodiode geschaltet ist, und einen zweiten Widerstand (205), der zwischen die zweite Elektrode (207a) der zweiten Photodiode und die dritte Elektrode (207b) geschaltet ist, ausgestattet ist.

22. Ein optisches Bauelement wie in Anspruch 21 definiert, worin der erste Widerstand (105) einen Widerstandswert ($R_1$) besitzt, der Eigenschaften repräsentiert, die sich bei einer ersten Wellenlänge einfallenden Lichtes drastisch ändern, und der zweite Widerstand (205) einen Widerstandswert ($R_2$) besitzt, der Eigenschaften repräsentiert, die sich bei einer zweiten Wellenlänge einfallenden Lichtes drastisch ändern.

23. Ein optisches Bauelement wie in Anspruch 21 definiert, das desweiteren mit einem ersten Gleichstromversorgungsgerät (106), das mit dem ersten Widerstand (105) in Reihe geschaltet ist und eine Sperrvorspannung zwischen den ersten und zweiten Halbleiterschichten (103, 104) anlegt, und einem zweiten Gleichstromversorgungsgerät (206), das mit dem zweiten Widerstand in Reihe geschaltet ist und eine Sperrvorspannung zwischen dem Halbleitersubstrat (208) und der zweiten Halbleiterschicht (104) anlegt, ausgestattet ist.

24. Ein Bauelement wie in Anspruch 7 beansprucht, mit einer ersten Photodiode, die unter den einfallenden Lichtsignalen ein monochromatisches Lichtsignal der längsten Wellenlänge ($\lambda_1$) länger als eine Grenzwellenlänge absorbiert und es in einen Photostrom umwandelt und die Lichtsignale kürzerer Wellenlänge als der Grenzwellenlänge überträgt, und einem zweiten optischen Element, das unter den einfallenden Lichtsignalen das Licht der zweiten längsten Wellenlänge ($\lambda_2$), die kürzer als die Grenzwellenlänge ist, absorbiert und es in einen Photostrom umwandelt, worin:
die zweite Photodiode (II) umfaßt:
ein Halbleitersubstrat (208), das mit Fremdatomen vom ersten Leitfähigkeitstyp dotiert ist;
eine zweite auf einer Oberfläche des Halbleitersubstrats (208) erzeugte eigenleitende Schicht (202), in der eine Licht absorbierende Multi-Quantenwannenschicht (201) eingelassen ist;
eine dritte auf einer Oberfläche der zweiten eigenleitenden Schicht (202) erzeugte Halbleiterschicht (204) vom zweiten Leitfähigkeitstyp, die mit Fremdatomen vom zweiten Leitfähigkeitstyp dotiert ist;
eine vierte auf einem Teil einer Oberfläche der dritten Halbleiterschicht (204) vom zweiten Leitfähigkeitstyp erzeugte Elektrode (207a);

eine dritte auf der anderen Oberfläche des Halbleitersubstrats (208) erzeugte Elektrode (207b); und
die erste Photodiode umfaßt:
eine zweite bei einem Teil einer Oberfläche der dritten Halbleiterschicht (204) vom zweiten Leitfähigkeitstyp via einer eine Halbleiterschicht umfassenden Trennschicht auf der dritten Halbleiterschicht (204) erzeugte Halbleiterschicht (103), die mit Fremdatomen vom ersten Leitfähigkeitstyp dotiert ist;
eine erste auf einem Teil einer Oberfläche der zweiten Halbleiterschicht (103) erzeugte eigenleitende Schicht (102), in der eine Licht absorbierende Multi-Quantenwannenschicht (101) eingelassen ist;
eine erste auf einer Oberfläche der ersten eigenleitenden Schicht (102) erzeugte Halbleiterschicht (104), die mit Fremdatomen vom zweiten Leitfähigkeitstyp dotiert ist;
eine auf einem Teil einer Oberfläche der ersten Halbleiterschicht (104) erzeugte, mit einem optischen Fenster versehene erste Elektrode (107a); und
eine zweite mit der zweiten Halbleiterschicht (103) verbundene Elektrode (107b).

25. Ein optisches Bauelement wie in Anspruch 24 definiert, worin die erste Photodiode (I) zwischen der ersten Halbleiterschicht (104) und der ersten Elektrode (107a) mit einer vierten Halbleiterschicht (108) vom zweiten Leitfähigkeitstyp ausgestattet ist.

26. Ein optisches Bauelement wie in Anspruch 25 definiert, worin die vierte Halbleiterschicht vom zweiten Leitfähigkeitstyp an einer zu einem optischen Fenster der ersten Elektrode (107a) passenden Position mit einer Öffnung versehen ist.

27. Ein optisches Bauelement wie in Anspruch 24 definiert, worin die zweite Photodiode zwischen dem Halbleitersubstrat (208) und der zweiten eigenleitenden Schicht (202) mit einer fünften Halbleiterschicht (203) vom der ersten Leitfähigkeit ausgestattet ist.

28. Ein optisches Bauelement wie in Anspruch 24 definiert, das desweiteren mit einem ersten Widerstand (105), der zwischen die erste Elektrode (107a) und die zweite Elektrode (107b) geschaltet ist, und einem zweiten Widerstand (205), der zwischen die vierte Elektrode (207a) und die dritte Elektrode (207b) geschaltet ist, ausgestattet ist.

29. Ein optisches Bauelement wie in Anspruch 28 definiert, worin der erste Widerstand (105) einen

Widerstandswert (R$_1$) besitzt, der Eigenschaften repräsentiert, die sich bei der ersten Wellenlänge einfallenden Lichtes drastisch ändern, und der zweite Widerstand (205) einen Widerstandswert (R$_2$) besitzt, der Eigenschaften repräsentiert, die sich bei der zweiten Wellenlänge einfallenden Lichtes drastisch ändern.

30. Ein optisches Bauelement wie in Anspruch 28 definiert, das desweiteren mit einem ersten Gleichstromversorgungsgerät (106), das mit dem ersten Widerstand (105) in Reihe geschaltet ist und eine Sperrvorspannung an die erste Halbleiterschicht (104) und zweite Halbleiterschicht (103) anlegt, und einem zweiten Gleichstromversorgungsgerät (206), das mit dem zweiten Widerstand (205) in Reihe geschaltet ist und eine Sperrvorspannung an das Halbleitersubstrat (208) und die dritte Halbleiterschicht (204) anlegt, ausgestattet ist.

31. Ein optisches Bauelement wie in Anspruch 24 definiert, worin die zweite Photodiode (II) zwischen dem Halbleitersubstrat (208) und der zweiten eigenleitenden Schicht (202) mit einer fünften Halbleiterschicht (203) vom ersten Leitfähigkeitstyp ausgestattet ist, wobei in dem Halbleitersubstrat (208) eine Öffnung für Ausgangslicht (λ$_3$) bereitgestellt ist, das von der zweiten eigenleitenden Schicht (202) und der fünften Halbleiterschicht (203) übertragen worden ist, und ein Ausgabefenster an einer zu der Öffnung passenden Position der dritten Elektrode (207b) erzeugt ist.

32. Ein optisches Bauelement wie in Anspruch 31 definiert, das desweiteren mit einem ersten Widerstand (105), der zwischen die erste Elektrode (107a) und die zweite Elektrode (107b) geschaltet ist, und einen zweiten Widerstand (205), der zwischen die vierte Elektrode (207a) und die dritte Elektrode (207b) geschaltet ist, ausgestattet ist.

33. Ein optisches Bauelement wie in Anspruch 32 definiert, worin der erste Widerstand (105) einen Widerstandswert (R$_1$) besitzt, der Eigenschaften repräsentiert, die sich bei der ersten Wellenlänge einfallenden Lichtes drastisch ändern, und der zweite Widerstand (205) einen Widerstandswert (R$_2$) besitzt, der Eigenschaften repräsentiert, die sich bei der zweiten Wellenlänge einfallenden Lichtes drastisch ändern.

34. Ein optisches Bauelement wie in Anspruch 32 definiert, das desweiteren mit einem ersten Gleichstromversorgungsgerät (106), das mit dem ersten Widerstand (105) in Reihe geschaltet ist und eine Sperrvorspannung an die erste Halbleiterschicht (104) und zweite Halbleiterschicht (103) anlegt, und einem zweiten Gleichstromversorgungsgerät (206), das mit dem zweiten Widerstand (205) in Reihe geschaltet ist und eine Sperrvorspannung an das Halbleitersubstrat (208) und die dritte Halbleiterschicht (204) anlegt, ausgestattet ist.

35. Ein Lichtdetektionsverfahren, das umfaßt:
   Bereitstellen eines Lichtdetektionselementes, das so geartet ist, daß ein äußerer Widerstand (105) in Reihe mit einem optischen Element (103, 102, 104) der p-i-n-Typ-Struktur geschaltet ist, das eine Licht absorbierende Schicht mit einer Quantenwannenstruktur (101) besitzt, um eine Spannung durch den durch das einfallende Licht (λ) erzeugten Photostrom zu erzeugen, und so, daß die Absorptionseigenschaften bei der Wellenlänge des einfallenden Lichtes des optischen Elementes eine Hysterese besitzen oder sich bei irgendeiner Wellenlänge diskontinuierlich ändern; und
   selektives Umwandeln allein eines Lichtsignals einer bestimmten Wellenlänge länger als eine Grenzwellenlänge in ein elektrisches Signal und Bewirken, daß Signale kürzerer Wellenlänge als die Grenzwellenlänge als Ausgangssignale übertragen werden.

36. Eine Lichtdetektionsvorrichtung mit:
   einer Vielzahl von Lichtdetektionselementen, die so geartet sind, daß äußere Widerstände (105, 205) in Reihe mit einer Vielzahl von optischen Elementen (I, II) der p-i-n-Typ-Struktur geschaltet sind, die Quantenwannenstrukturen (101, 201) für Licht absorbierende Schichten besitzen, um eine Spannung durch den durch das einfallende Licht erzeugten Photostrom zu erzeugen, und so, daß die Absorptionseigenschaften gegenüber der Wellenlänge eine Hysterese besitzen oder sich diskontinuierlich bei entsprechenden Wellenlängen ändern; und
   einem Element (I), das ganz selektiv nur das Lichtsignal längerer Wellenlänge als der ersten Grenzwellenlänge in elektrische Signale umwandelt und bewirkt, daß Signale kürzerer Wellenlänge als die erste Grenzwellenlänge zum zweiten Element (II) übertragen werden;
   dem zweiten Element (II), das selektiv das Lichtsignal längerer Wellenlänge als der zweiten Grenzwellenlänge in ein elektrisches Signal umwandelt und bewirkt, daß Signale kürzerer Wellenlänge als die zweite Grenzwellenlänge zu einem dritten Element übertragen werden; und
   einem n-ten Element, das ganz selektiv das Lichtsignal längerer Wellenlänge als der n-ten Grenzwellenlänge in ein elektrisches Signal umwandelt und bewirkt, daß Signale kürzerer Wellenlänge als der n-ten Grenzwellenlänge zum (n+1)-ten Element übertragen werden.

37. Ein Bauelement wie in Anspruch 7 beansprucht, in der Form eines Photodetektors nach Art eines Wellenleiters, in dem eine p-i-n-Diodenstruktur, die in einer eigenleitenden Schicht eine Quantenwannenstruktur umfaßt, in vielfache Abschnitte unterteilt ist, wobei eine Spannung zwischen der oberen Elektrode der entsprechenden Stufe und der unteren Elektrode über einen Widerstand angelegt ist, und monochromatische Lichtsignale getrennt werden, um bei den entsprechenden Abschnitten detektiert zu werden.

**Revendications**

1. Méthode pour détecter un faisceau optique ($\lambda$) multiplexé selon la longueur d'onde, laquelle méthode consiste à :

agencer une photodiode PIN à puits quantique multiple (101, 102, 103, 104, 107a, 107b) dans le trajet dudit faisceau optique multiplexé selon la longueur d'onde ($\lambda$);

appliquer, à ladite photo-diode, une tension de polarisation inverse à travers une résistance en série externe (105) qui est telle que ladite photodiode (101, 102, 103, 104, 107a, 107b) soit accordée pour avoir une bistabilité du photocourant à une longueur d'onde de coupure ($\lambda_4$) se trouvant entre les longueurs d'onde composantes dudit faisceau ($\lambda$);

détecter une composante du faisceau d'une longueur d'onde plus importante que ladite longueur d'onde de coupure ($\lambda_4$); et

laisser passer une ou plusieurs composantes du faisceau d'une longueur d'onde plus courte que ladite longueur d'onde de coupure ($\lambda_4$).

2. Méthode selon la revendication 1, laquelle méthode consiste à :

agencer des première et seconde photodiodes PIN à puits quantique multiple (I, II) optiquement en série dans le trajet dudit faisceau optique multiplexé selon la longueur d'onde ($\lambda$);

appliquer, à ladite première photodiode (I), une tension de polarisation inverse qui est telle que ladite première photodiode (I) soit accordée pour avoir une bistabilité du photocourant à une longueur d'onde de coupure se trouvant entre des première et seconde longueurs d'onde composantes;

($\lambda_1$, $\lambda_2$) dudit faisceau.

Détecter ladite première composante ($\lambda_1$) en utilisant ladite première photodiode, laquelle première composante est d'une longueur d'onde plus grande que celle de ladite seconde composante ($\lambda_2$);

faire passer ladite seconde composante à travers ladite première photodiode (I) vers ladite seconde photodiode (II);

appliquer, à ladite seconde photodiode (II) une tension de polarisation inverse qui est telle que ladite seconde photodiode (II) soit accordée pour détecter ladite seconde composante ($\lambda_2$); et

détecter ladite seconde composante en utilisant ladite seconde photodiode (II).

3. Méthode selon la revendication 2 où :

lesdites première et seconde photodiodes (I, II) sont agencées dans le trajet d'un faisceau comprenant lesdites première et seconde composantes ($\lambda_1$, $\lambda_2$) et au moins une troisième composante ($\lambda_3$) d'une plus courte longueur d'onde;

ladite tension de polarisation inverse appliquée à ladite seconde photodiode (II) est telle que ladite seconde photodiode (II) soit accordée pour avoir une bistabilité du photocourant à une longueur d'onde de coupure se trouvant entre lesdites seconde et troisième composantes ($\lambda_2$, $\lambda_3$); et

ladite troisième composante ($\lambda_3$) passe par lesdites première et seconde photodiodes (I, II).

4. Elément optique approprié à la mise en oeuvre de la méthode selon la revendication 2, lequel élément comprend:

des première et seconde photodiodes PIN à puits quantique multiple (I, II) agencées optiquement en série, les électrodes (107a) des photodiodes (I, II) permettant la transmission du faisceau optique; des résistances externes respectives (105a, 105b) connectées en série avec lesdites première et seconde photodiodes PIN (I, II);

un premier moyen d'application d'une tension de polarisation inverse (106a) connecté en série à la première desdites résistances externes (105a) à travers ladite première photodiode, lequel moyen sert à accorder ladite première photodiode (I) pour qu'elle ait une bistabilité du photocourant à une longueur d'onde de coupure plus courte qu'une première longueur d'onde ($\lambda_1$); et un second moyen d'application de tension de polarisation inverse (106b) connecté en série avec la seconde desdites résistances externes (105b) à travers ladite seconde photodiode (II), lequel moyen sert à accorder ladite seconde photodiode (II) pour détecter un rayonnement optique d'une longueur d'onde plus courte que ladite longueur d'onde de coupure.

**5.** Dispositif selon la revendication 4 où lesdites première et seconde photodiodes (I, II) sont empilées l'une sur l'autre et sont telles qu'un trajet de rayonnement optique soit offert dans une direction qui est verticale aux couches p, i et n (103, 102, 104) desdites première et seconde photodiodes (I, II).

**6.** Dispositif selon la revendication 4 où lesdites première et seconde photodiodes (I, II) sont agencées côte à côte et elles sont telles qu'un trajet de rayonnement optique soit formé dans une direction qui est parallèle aux couches p, i et n (306, 305, 304) desdites première et seconde photodiodes (I, II).

**7.** Elément de détection de la lumière tel que défini à la revendication 5 où lesdites première et seconde photodiodes (I, II) ont des structures de puits quantique différentes (101, 202) de manière que les couches d'absorption optique de la structure de puits quantique convertisse la lumière d'une longueur d'ondes différente en signaux électriques.

**8.** Elément de détection de la lumière tel que défini à la revendication 5 où les résistances externes (105, 205) connectées en série à chacune des première et seconde photodiodes respectives (I, II) ont des valeurs différentes de résistance ($R_1$, $R_2$) de manière que les couches d'absorption optique de la structure de puits quantique (102, 202) convertisse les signaux lumineux à une longueur d'onde différente en signaux électriques.

**9.** Elément de détection de la lumière tel que défini à la revendication 5 qui est de plus pourvu d'un certain nombre d'alimentations en courant continu (106, 206) qui sont connectées en série aux résistances externes (105, 205) connectées en série aux photodiodes (I, II), lesdites différentes alimentations en courant continu ont différentes valeurs de tension, des couches d'absorption optique de la structure de puits quantique respectives (101, 102) convertissent les signaux lumineux d'une longueur d'onde différente en signaux électriques.

**10.** Elément de détection de la lumière tel que défini à la revendication 5 où lesdites photodiodes (I, II) ont respectivement des couches semi-conductrices p-i-n (103, 102, 104; 203, 202, 204) et une couche d'absorption optique de la structure de puits quantique (101; 201) est produite dans la couche semi-conductrice du type i (102, 202).

**11.** Elément de détection de la lumière tel que défini à la revendication 10 où une couche de séparation comprenant une couche semi-conductrice du type i est prévue entre les photodiodes.

**12.** Elément de détection de la lumière tel que défini à la revendication 10 où lesdites photodiodes adjacentes ont des couches semi-conductrices du type p-i-n en ordre de stratification inverse (103, 102, 104, 202, 203) et une (104) d'une couche semi-conductrice du type p ou n est utilisée en commun.

**13.** Dispositif selon la revendication 5 où ladite première photodiode absorbe un signal lumineux de la première longueur d'onde ou la plus grande ($\lambda_1$) parmi les signaux de lumière incidente et le convertit en un photocourant lumineux et transmet les signaux lumineux d'une longueur d'onde plus courte que ladite plus grande longueur d'onde ($\lambda_1$) et une seconde photodiode qui absorbe le signal lumineux de la seconde plus grande longueur d'onde ($\lambda_2$) qui est plus courte que la première plus grande longueur d'onde ($\lambda_1$) parmi les signaux lumineux incidents et le convertit en un photocourant, où

ladite seconde photodiode comprend :

un substrat semi-conducteur (208) dans lequel sont dopées des impuretés d'un premier type de conductivité;

une seconde couche intrinsèque (202) dans laquelle est noyée une couche d'absorption optique à puits quantique multiple qui est produite sur une surface dudit substrat semi-conducteur (208);

une seconde couche semi-conductrice de la seconde photodiode (104) dans laquelle sont dopées des impuretés d'un second type de conductivité, qui est produite sur une surface de ladite seconde couche intrinsèque (202);

une deuxième électrode de la seconde photodiode (207a) produite sur une partie d'une surface de ladite seconde couche semi-conductrice (104);

une troisième électrode (207b) produite sur l'autre surface dudit substrat semi-conducteur (208); et

ladite première photodiode comprend :

une seconde couche semi-conductrice (104) de la première photodiode et une seconde électrode (207a) de la première photodiode;

une première couche intrinsèque (102) dans laquelle est enfouie une couche d'absorption optique de puits quantique multiple (101), produite sur une partie d'une surface de la seconde couche semi-conductrice (104) de ladite première photodiode;

une première couche semi-conductrice (103) dans laquelle sont dopées des impuretés d'un premier type de conductivité, qui est produite sur une surface de ladite première couche intrinsèque (102) et

une première électrode (107) pourvue d'une fenêtre optique par laquelle pénètre la lumière ($\lambda_1$, $\lambda_2$), qui est produite sur une partie d'une surface de ladite première couche semi-conductrice (103).

14. Elément optique tel que défini à la revendication 13 où ladite première photodiode (I) a une seconde couche semi-conductrice (108) du premier type de conductivité entre ladite première couche semi-conductrice (103) et la première électrode (107).

15. Elément optique tel que défini à la revendication 14 où ladite seconde couche semi-conductrice (108) du premier type de conductivité est pourvue d'une ouverture en une position correspondant à la fenêtre optique de ladite première électrode (107).

16. Elément optique tel que défini à la revendication 13 où ladite seconde photodiode (II) est pourvue d'une troisième couche semi-conductrice (203) d'un premier type de conductivité entre ledit substrat semi-conducteur (208) et ladite seconde couche intrinsèque (202).

17. Elément optique tel que défini à la revendication 13 qui comprend de plus une première résistance (105) connectée entre la première électrode (107) et la deuxième électrode (207a) de ladite première photodiode et une seconde résistance (205) connectée entre la deuxième électrode (207a) de ladite seconde photodiode et ladite troisième électrode (207b).

18. Elément optique tel que défini à la revendication 17 où ladite première résistance (105) a une valeur ($R_1$) représentant des caractéristiques changeant dramatiquement à une première longueur d'onde de lumière incidente et ladite seconde résistance (205) à une valeur ($R_2$) représentant des caractéristiques changeant dramatiquement à une seconde longueur d'onde de la lumière incidente.

19. Elément optique tel que défini à la revendication 17 qui est de plus pourvu d'une première alimentation en courant continu (106) qui est connectée en série avec ladite première résistance (105) et qui donne une polarisation inverse entre lesdites première et seconde couches semiconductrice (103, 104) et une seconde alimentation en courant continu (206) qui est connectée en série avec ladite seconde résistance (205) qui donne une polarisation inverse entre ledit substrat semiconducteur (208) et ladite seconde couche semiconductrice (104).

20. Elément optique tel que défini à la revendication 13 où ladite seconde photodiode (II) a une troisième couche semi-conductrice (203) d'un premier type de conductivité entre ledit substrat semiconducteur (208) et ladite seconde couche intrinsèque (202), un trou pour émettre de la lumière (Figure 13) est prévu sur ledit substrat semiconducteur (208) et une fenêtre de sortie est produite en une position qui correspond à une ouverture dans ladite troisième électrode (207b).

21. Elément optique tel que défini à la revendication 20 qui est de plus pourvu d'une première résistance (105) connectée entre ladite première électrode (107) et ladite deuxième électrode (207a) de la première photodiode et une seconde résistance (205) connectée entre ladite deuxième électrode (207a) de la seconde photodiode et ladite troisième électrode (207b).

22. Elément optique tel que défini à la revendication 21 où ladite première résistance (105) a une valeur ($R_1$) représentant des caractéristiques changeant dramatiquement à une première longueur d'onde de lumière incidente et ladite seconde résistance (205) a une valeur ($R_2$) représentant des caractéristiques changeant dramatiquement à une seconde longueur d'onde de la lumière incidente.

23. Elément optique tel que défini à la revendication 21, qui est de plus pourvu d'une première alimentation en courant continu (106) qui est connectée en série avec ladite première résistance (105) et qui donne une polarisation inverse entre lesdites première et seconde couches semiconductrices (103, 104) et d'une seconde alimentation en courant continu (206) qui est connectée en série avec ladite seconde résistance et qui donne une polarisation inverse entre ledit substrat semiconducteur (208) et ladite seconde couche semiconductrice (104).

24. Dispositif selon la revendication 7 ayant une première photodiode qui absorbe un signal de lumière monochromatique de la plus grande longueur d'onde ($\lambda_1$) plus longue qu'une longueur d'onde critique parmi les signaux de lumière incidente et le convertit en photocourant et transmet les signaux lumineux d'une longueur d'onde plus courte que ladite longueur d'onde critique et un second élément optique qui absorbe la lumière de la seconde plus grande longueur d'onde ($\lambda_2$) qui est plus courte que la longueur d'onde critique parmi les signaux de lumière incidente et la convertit en un photocourant, où

ladite seconde photodiode (II) comprend :

un substrat semi-conducteur (208) dans lequel sont dopées des impuretés d'un premier type de conductivité;

une seconde couche intrinsèque (202) dans laquelle est enfouie une couche d'absorption optique d'un puits quantique multiple (201), qui est produite sur une surface dudit substrat semi-conducteur (208);

une troisième couche semi-conductrice (204) du second type de conductivité dans laquelle sont dopées des impuretés du second type de conductivité, produite sur une surface de ladite seconde couche intrinsèque (202);

une quatrième électrode (207a) produite sur une partie d'une surface de ladite troisième couche semi-conductrice (204) du second type de conductivité;

une troisième électrode (207b) produite sur l'autre surface dudit substrat semi-conducteur (208) et

ladite première photodiode comprend :

une seconde couche semi-conductrice (103) dans laquelle sont dopées des impuretés du premier type de conductivité, produite en une partie sur une surface de ladite troisième couche semi-conductrice (204) du second type de conductivité via une couche de séparation comprenant une couche semiconductrice sur la troisième couche semi-conductrice (204);

une première couche intrinsèque (102) dans laquelle est noyée une couche d'absorption optique d'un puits multiquantique produite sur une partie d'une surface de ladite seconde couche semi-conductrice (103);

une première couche semi-conductrice (104) dans laquelle sont dopées des impuretés du second type de conductivité, produite sur une surface de ladite première couche intrinsèque (102);

une première électrode (107a) pourvue d'une fenêtre optique, produite sur une partie d'une surface de ladite première couche semi-conductrice (104) et

une seconde électrode (107b) connectée à la seconde couche semi-conductrice (103).

25. Elément optique tel que défini à la revendication 24 où ladite première photodiode (I) est pourvue d'une quatrième couche semi-conductrice (108) du second type de conductivité entre ladite première couche semi-conductrice (104) et ladite première électrode (107a).

26. Elément optique tel que défini à la revendication 25 où ladite quatrième couche semi-conductrice du second type de conductivité est pourvue d'une ouverture en une position correspondante à une fenêtre optique de ladite première électrode (107a).

27. Elément optique tel que défini à la revendication 24 où ladite seconde photodiode est pourvue d'une cinquième couche semi-conductrice (203) du premier type de conductivité entre ledit substrat semi-conducteur (208) et ladite seconde couche intrinsèque (202).

28. Elément optique tel que défini à la revendication 24 qui est de plus pourvu d'une première résistance (105) connectée entre ladite première électrode (107a) et ladite deuxième électrode (107b) et d'une seconde résistance (205) connectée entre ladite quatrième électrode (207a) et ladite troisième électrode (207b).

29. Elément optique tel que défini à la revendication 28 où ladite première résistance (105) a une valeur ($R_1$) repésentant des caractéristiques changeant dramatiquement à la première longueur d'onde de la lumière incidente et ladite seconde résistance (205) a une valeur ($R_2$) représentant des caractéristiques changeant dramatiquement à la seconde longueur d'onde de la lumière incidente.

30. Elément optique tel que défini à la revendication 28, qui est de plus pourvu d'une première alimentation en courant continu (106) qui est connectée en série avec ladite première résistance (105) et qui donne une polarisation inverse à ladite première couche semi-conductrice (104) et ladite deuxième couche semi-conductrice (103) et une seconde alimentation en courant continu (206) qui est connectée en série avec ladite seconde résistance (205) et qui donne une polarisation inverse audit substrat semi-conducteur (208) et à ladite troisième couche semi-conductrice (204).

31. Elément optique tel que défini à la revendication 24 où ladite seconde photodiode (II) est pourvue d'une cinquième couche semi-conductrice du premier type de conductivité (203) entre ledit substrat semi-conducteur (208) et ladite seconde couche intrinsèque (202), une ouverture pour la sortie de la lumière ($\lambda_3$) qui a été transmise par ladite seconde couche intrinsèque (202) et ladite cinquième couche semi-conductrice (203) est prévue dans ledit substrat semi-conducteur (208) et une fenêtre de sortie est produite en une position de ladite troisième électrode (207b) qui correspond à ladite ouverture.

32. Elément optique tel que défini à la revendication 31 qui est de plus pourvu d'une première résistance (105) connectée entre ladite première électrode (107a) et ladite deuxième électrode (107b) et d'une seconde résistance (205) qui est connectée entre ladite quatrième électrode (207a) et ladite troisième électrode (207b).

33. Elément optique tel que défini à la revendication 32 où ladite première résistance (105) a une valeur $(R_1)$ représentant des caractéristiques changeant dramatiquement à la première longueur d'onde de la lumière incidente et ladite seconde résistance (205) a une valeur $(R_2)$ représentant des caractéristiques changeant dramatiquement à la seconde longueur d'onde de la lumière incidente.

34. Elément optique tel que défini à la revendication 32 qui est de plus pourvu d'une première alimentation en courant continu (106) qui est connectée en série avec ladite première résistance (105) et qui donne une polarisation inverse à ladite première couche semi-conductrice (104) et à ladite deuxième couche semi-conductrice (103) et une seconde alimentation en courant continu (206) qui est connectée en série avec ladite seconde résistance (205) et qui donne une polarisation inverse audit substrat semi-conducteur (208) et à ladite troisième couche semi-conductrice (204).

35. Méthode de détection de la lumière consistant à :
prévoir un élément de détection de la lumière constitué de façon qu'une résistance externe (105) soit connectée en série à un élement optique d'une structure du type p-i-n (103, 102, 104) ayant une couche d'absorption optique ayant une structure de puits quantique (101) de façon à produire une tension par le photocourant produit par la lumière incidente $(\lambda)$ et de manière que les caractéristiques d'absorption à la longueur d'onde de la lumière incidente dudit élément optique aient une hystérésis ou changent de façon discontinue à une certaine longueur d'onde; et
convertir sélectivement uniquement un signal lumineux d'une longueur d'onde particulière plus grande qu'une longueur d'onde critique en un signal électrique et forcer les signaux d'une longueur d'onde plus courte que la longueur d'onde critique à être transmis en tant que signal de sortie.

36. Dispositif de détection de la lumière comprenant :
un certain nombre d'éléments de détection de la lumière qui sont constitués de manière que des résistances externes (105, 205) soient connectées en série à un certain nombre d'éléments optiques à structure du type p-i-n (1, 2) ayant des structures de puits quantique (101, 201) pour des couches d'absorption optique de façon à générer une tension par le photocourant produit par la lumière incidente et de manière que les caractéristiques d'absorption par rapport à la longueur d'onde aient une hystérésis ou changent de façon discontinue respectivement, à différentes longueurs d'onde; et
un élément (I) convertissant assez sélectivement uniquement le signal lumineux d'une longueur d'onde plus grande que la première longueur d'onde critique en signaux électriques et forçant les signaux de longueurs d'onde plus courtes que la première longueur d'onde critique à être transmis au second élément (II);
ledit deuxième élément (II) convertissant sélectivement le signal lumineux de la longueur d'onde plus grande que la seconde longueur d'onde critique en un signal électrique et forçant les signaux à des longueurs d'onde plus courtes que la seconde longueur d'onde critique à être transmis à un troisième élément; et
un nième élément convertissant assez sélectivement le signal lumineux d'une longueur d'onde plus grande que la nième longueur d'onde critique en un signal électrique et forçant les signaux à des longueurs d'onde plus courtes que la nième longueur d'onde critique à être transmis au (n+1)ième élément.

37. Dispositif selon la revendication 7 sous la forme d'un photodétecteur du type à guide d'onde où une structure de diodes p-i-n comprenant une structure à puits quantique dans une couche intrinsèque est divisée en segments multiples, une tension est appliquée entre l'électrode supérieure de l'étage respectif et l'électrode inférieure via un résistance, des signaux de lumière monochromatique sont séparés pour être détectés aux segments respectifs.

F I G .1.(PRIOR ART)

F I G .2.(PRIOR ART)

F I G .3.(PRIOR ART)

F I G .4.

F I G .5.

(a)

(b)

(c)

F I G .6.

# F I G .7.

incident light λ

105
R

106

Vex

I

107a
103
101
102
104
107b

p
i
n

Pin

Pout

output light

# F I G .8.

(a)

I
V5 V4 V3 V2 V1 V0

λ7 λ6 λ5 λ4 λ3 λ2 λ1 λ0 λ

(b)

I
R2   R1   R0 = 0 Ω
λ7 λ6 λ5 λ4 λ3 λ2 λ1

V5 V4 V3 V2 V1 V0 Vin

(c)

I
R2   R1   R0 = 0 Ω

λ7 λ6 λ5 λ4 λ3 λ2 λ1 λ0 λ

(d)

Pout   R = R1   R = R2

λ7 λ6 λ5 λ4 λ3 λ2 λ1 λ0 λ

R0 = 0 Ω

EP 0 385 803 B1

FIG. 9.

26

FIG.10.

FIG.11.

(a)     upper stage element

(b)     lower stage element

FIG .12.

FIG .13.

F I G .14.

EP 0 385 803 B1

F I G .15.

characteristics of the initial stage detector portion

characteristics of the next stage detector portion

light current

wavelength

λ1

λ2

λ3

EP 0 385 803 B1